# EUROPEAN PATENT APPLICATION

(11) **EP 4 485 543 A1**
(43) Date of publication of application: **01.01.2025**
(21) Application number: 24166277.4
(22) Date of filing: 26.03.2024
(51) Int. Cl.: H01L 29/06, H01L 29/423, H01L 29/775, H01L 29/66, H01L 29/08

(54) **SEMICONDUCTOR DEVICES**

(30) Priority: 29.06.2023 KR 20230084069; 10.01.2024 US 202418409523
(71) Applicant: Samsung Electronics Co., Ltd., Suwon-si, Gyeonggi-do 16677 (KR)
(72) Inventor: KIM, Sungmin, 16677 Suwon-si (KR)
(74) Representative: Marks & Clerk LLP

(57) **Abstract**

A semiconductor device comprising: a substrate including an active pattern; a channel pattern on the active pattern, wherein the channel pattern includes a plurality of semiconductor patterns; a source/drain pattern connected to the plurality of semiconductor patterns; a gate electrode extending in a first direction on the channel pattern, wherein the gate electrode includes an inner gate electrode between first and second semiconductor patterns among the plurality of semiconductor patterns; and an inner gate spacer between the inner gate electrode and the source/drain pattern, wherein the inner gate spacer includes a center portion and an edge portion, the center portion has a first thickness in a second direction, the edge portion has a second thickness in the second direction, the first thickness is greater than the second thickness, the first and second semiconductor patterns are adjacent to each other in a third direction.

## Description

### BACKGROUND

The inventive concepts relate to semiconductor devices and methods of manufacturing the same, and more particularly, relate to semiconductor devices including a field effect transistor and methods of manufacturing the same.

Semiconductor devices may include integrated circuits, which may comprise a metal oxide semiconductor field effect transistor (MOSFET). To meet an increasing demand for semiconductor devices with a small pattern size and a reduced design rule, the MOSFETs are being scaled down. The scale-down of the MOSFETs may lead to deterioration in operational properties of the semiconductor devices. A variety of studies are being conducted to overcome technical limitations associated with the scale-down of the semiconductor devices and to realize high performance semiconductor devices.

### SUMMARY

The inventive concepts of the present disclosures may provide semiconductor devices having improved reliability and electrical characteristics.

A semiconductor device according to some embodiments of the inventive concepts of the present disclosures may include a substrate including an active pattern; a channel pattern on the active pattern, wherein the channel pattern includes a plurality of semiconductor patterns spaced apart from each other; a source/drain pattern electrically connected to the plurality of semiconductor patterns; a gate electrode that extends in a first direction on the channel pattern, wherein the gate electrode includes an inner gate electrode that is between first and second semiconductor patterns among the plurality of semiconductor patterns; and an inner gate spacer between the inner gate electrode and the source/drain pattern, wherein the inner gate spacer includes a center portion and an edge portion that is adjacent to a first side of the center portion in the first direction, wherein the center portion has a first thickness in a second direction, wherein the edge portion has a second thickness in the second direction, wherein the first thickness is greater than the second thickness, wherein the first and second semiconductor patterns are adjacent to each other in a third direction, wherein the first direction is parallel with an upper surface of the substrate, wherein the second direction is parallel with the upper surface of the substrate and intersects with the first direction, and wherein the third direction is perpendicular to the upper surface of the substrate.

A semiconductor device according to some embodiments of the inventive concepts of the present disclosures may include a substrate including an active pattern; a channel pattern on the active pattern, wherein the channel pattern includes a plurality of semiconductor patterns spaced apart from each other; a source/drain pattern electrically connected to the plurality of semiconductor patterns; a gate electrode that extends in a first direction on the channel pattern, wherein the gate electrode includes an inner gate electrode that is between first and second semiconductor patterns among the plurality of semiconductor patterns; an inner gate spacer between the inner gate electrode and the source/drain pattern; and an inner high-k dielectric layer between the inner gate electrode and the inner gate spacer, wherein the inner gate spacer includes a first portion and a second portion that is adjacent to a first side of the first portion in the first direction, wherein the first portion includes a first outer surface in contact with the inner high-k dielectric layer, wherein the second portion includes a second outer surface in contact with the inner high-k dielectric layer, wherein the first outer surface is closer than the second outer surface to a center portion of the inner gate electrode, and wherein the first direction is parallel with an upper surface of the substrate. The first outer surface may be closer to the center portion of the inner gate electrode than the second outer surface in the second direction.

A semiconductor device according to some embodiments of the inventive concepts of the present disclosures may include a substrate including an active region; an active pattern on the active region; a device isolation layer adjacent to the active pattern; a channel pattern and a source/drain pattern on the active pattern, wherein the channel pattern includes a plurality of semiconductor patterns that are spaced apart from each other and stacked in a second direction, and wherein the source/drain pattern is electrically connected to the plurality of semiconductor patterns; a gate electrode that extends in a first direction on the channel pattern, wherein the gate electrode includes an inner gate electrode that is between first and second semiconductor patterns among the plurality of semiconductor patterns; a gate insulating layer between the first and second semiconductor patterns and the inner gate electrode, wherein the gate insulating layer includes an inner gate spacer between the inner gate electrode and the source/drain pattern; an inner high-k dielectric layer between the inner gate electrode and the inner gate spacer; and a gate spacer on a sidewall of the gate electrode, wherein the first and second semiconductor patterns are adjacent to each other in the second direction, wherein the inner gate spacer includes a first edge portion, a second edge portion spaced apart from the first edge portion in the first direction, and a center portion between the first edge portion and the second edge portion, wherein a thickness of the inner gate spacer in a third direction increases from the first edge portion toward the center portion, reaches a maximum value at the center portion, and decreases toward the second edge portion from the center portion, wherein the second direction is perpendicular to an upper surface of the substrate, wherein the first direction is parallel with the upper surface of the substrate, and wherein the third direction is parallel with the upper surface of the substrate and intersects with the first direction.

The described inner gate electrode may comprise or consist of a portion of the gate electrode.

At least some of the above and other features of the disclosure are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIGS. 1 to 3 are conceptual views illustrating logic cells of a semiconductor device according to some example embodiments of the inventive concepts.
FIG. 4 is a plan view illustrating a semiconductor device according to some example embodiments of the inventive concepts.
FIGS. 5A to 5D are cross-sectional views taken along lines A-A', B-B', C-C', and D-D' of FIG. 4, respectively.
FIG. 6A is an enlarged view illustrating an embodiment of region 'M' of FIG. 5A.
FIG. 6B is a cross-sectional view taken along line X-X' of FIG. 5B.
FIGS. 7A to 17B are cross-sectional views illustrating a method of manufacturing a semiconductor device according to some example embodiments of the inventive concepts.
FIGS. 18 and 19 are cross-sectional views taken along line X-X' of FIG. 5B according to some example embodiments of the inventive concepts.

### DETAILED DESCRIPTION

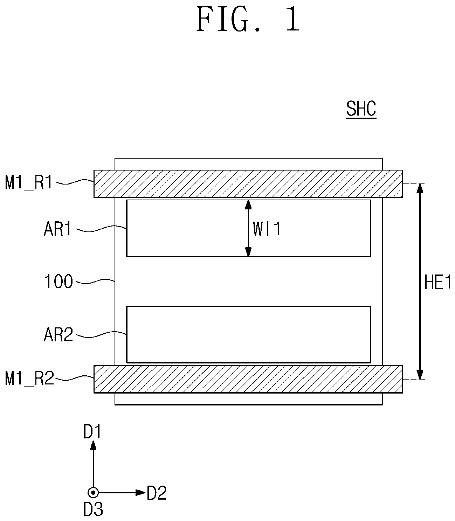

FIGS. 1 to 3 are conceptual views illustrating logic cells of a semiconductor device according to some example embodiments of the inventive concepts.

Referring to FIG. 1, a single height cell SHC may be provided. For example, a first power wiring M1_R1 and a second power wiring M1_R2 may be provided on a substrate 100. The first power wiring M1_R1 may be a passage through which a source voltage VSS, for example, a ground voltage is provided. The second power wiring M1_R2 may be a passage through which a drain voltage VDD, for example, a power voltage is provided.

The single height cell SHC may be defined between the first power wiring M1_R1 and the second power wiring M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. That is, the single height cell SHC may have a CMOS structure provided between the first power wiring M1_R1 and the second power wiring M1_R2. For example, the first active region AR1 may be an NMOSFET region, and the second active region AR2 may be a PMOSFET region.

Each of the first and second active regions AR1 and AR2 may have a single width W_I1 in a first direction D1. The first direction D1 may extend in parallel with an upper surface of the substrate 100. A length of the single height cell SHC in the first direction D1 may be defined as a first height HE1. The first height HE1 may be substantially equal to a distance (e.g., a pitch) between the first power wiring M1_R1 and the second power wiring M1_R2.

The single height cell SHC may constitute one logic cell. In this specification, a logic cell may mean a logic element (e.g., AND, OR, XOR, XNOR, inverter, etc.) that performs a specific function. That is, the logic cell may include transistors constituting logic elements and wirings connecting (e.g., electrically connecting) the transistors to each other. It will be understood that when an element or layer is referred to as being "connected to", or "coupled to" another element or layer, it may be directly on, connected to, or coupled to the other element or layer, or one or more intervening elements or layers may be present. In contrast, when an element is referred to as being "directly coupled," "directly connected," or "directly responsive" to, or "directly on," another element, there are no intervening elements present. In addition, "electrical connection" conceptually includes a physical connection and a physical disconnection.

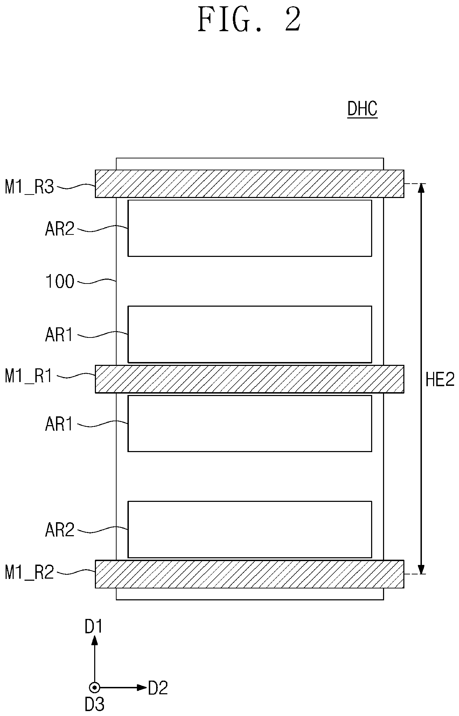

Referring to FIG. 2, a double height cell DHC may be provided. For example, a first power wiring M1_R1, a second power wiring M1_R2, and a third power wiring M1_R3 may be provided on a substrate 100. The first power wiring M1_R1 may be disposed between the second power wiring M1_R2 and the third power wiring M1_R3. The third power wiring M1_R3 may be a passage through which a source voltage VSS is provided.

The double height cell DHC may be defined between the second power wiring M1_R2 and the third power wiring M1_R3. The double height cell DHC may include two first active regions AR1 and two second active regions AR2.

One of the two second active regions AR2 may be adjacent to the second power wiring M1_R2. The other one of two second active regions AR2 may be adjacent to the third power wiring M1_R3. The two first active regions AR1 may be adjacent to the first power wiring M1_R1. When viewed in a plan view, the first power wiring M1_R1 may be disposed between the two first active regions AR1.

A length of the double height cell DHC in the first direction D1 may be defined as a second height HE2. The second height HE2 may be about twice the first height HE1 of FIG. 1. The two first active regions AR1 of the double height cell DHC may be grouped together to operate as one active region.

In the present inventive concepts, the double height cell DHC shown in FIG. 2 may be defined as a multi-height cell. Although not shown, the multi-height cell may include a triple height cell having a cell height of about three times that of a single height cell SHC in FIG. 1.

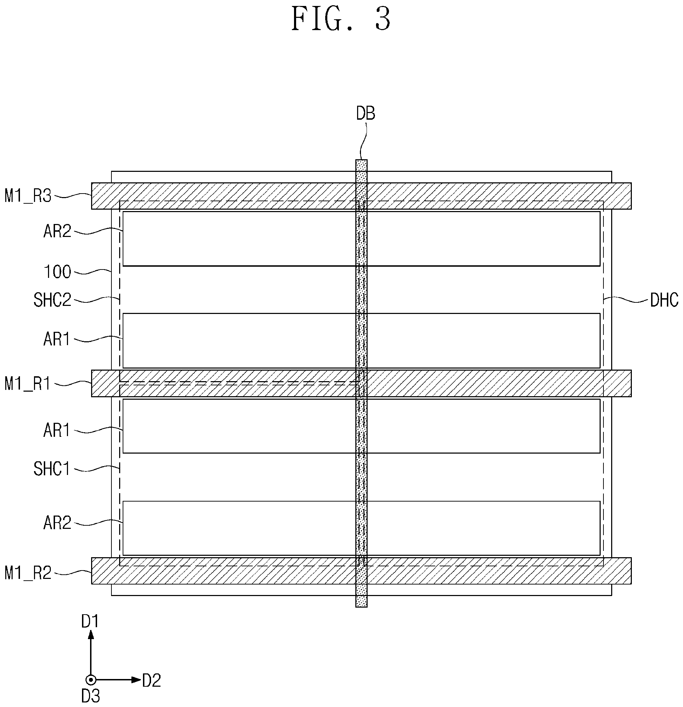

Referring to FIG. 3, a first single height cell SHC1, a second single height cell SHC2, and a double height cell DHC may be two-dimensionally disposed on a substrate 100. The first single height cell SHC1 may be disposed between first and second power wirings M1_R1 and M1_R2. The second single height cell SHC2 may be disposed between first and third power wirings M1_R1 and M1_R3. The second single height cell SHC2 may be adjacent to the first single height cell SHC1 in the first direction D1.

The double height cell DHC may be disposed between the second and third power wirings M1_R2 and M1_R3. The double height cell DHC may be adjacent to the first and second single height cells SHC1 and SHC2 in a second direction D2. The second direction D2 may extend parallel with the upper surface of the substrate 100. The first direction D1 and the second direction D2 may intersect (e.g., may be perpendicular) to each other.

A separation structure DB may be provided between the first single height cell SHC1 and the double height cell DHC and between the second single height cell SHC2 and the double height cell DHC. The active region of the double height cell DHC may be electrically separated from the active region of each of the first and second single height cells SHC1 and SHC2 by the separation structure DB.

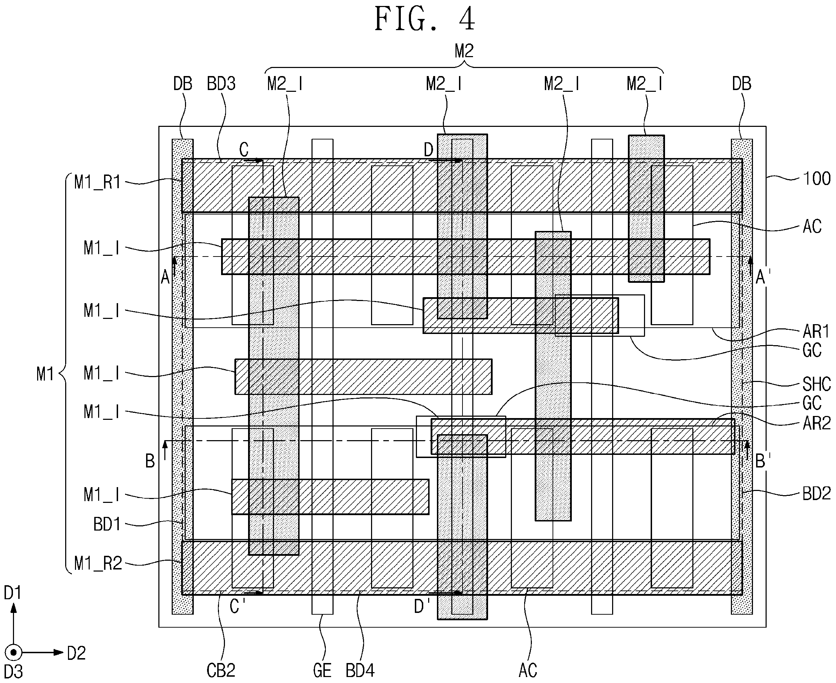

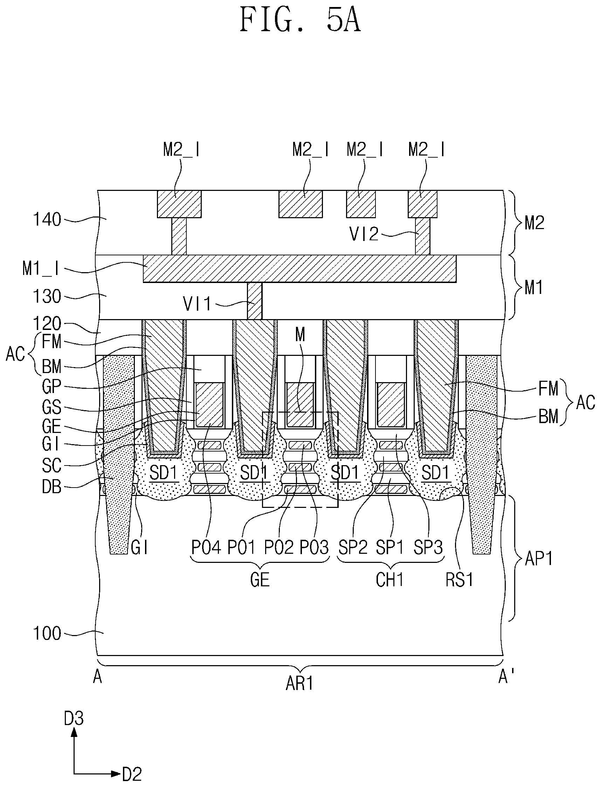

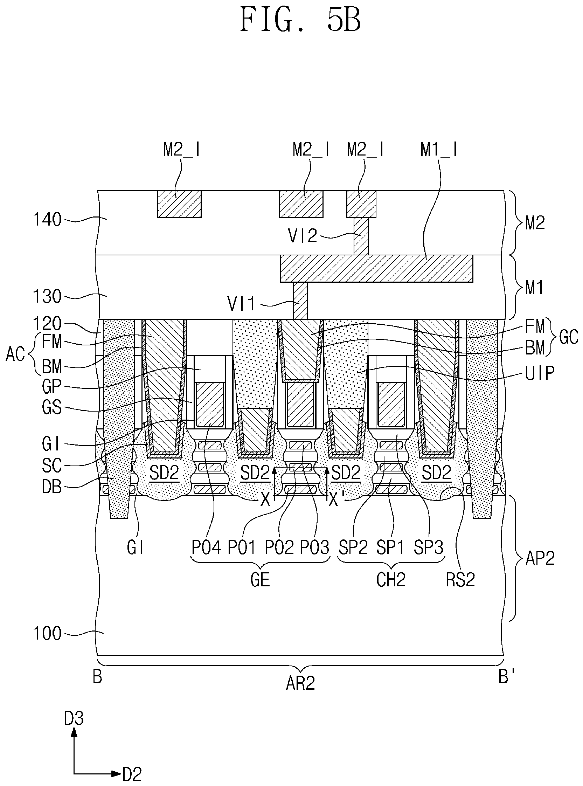

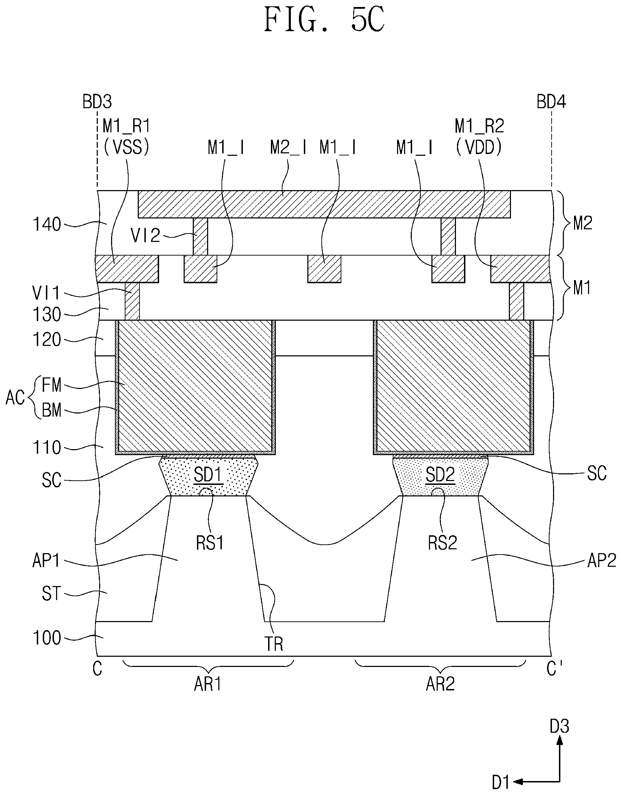

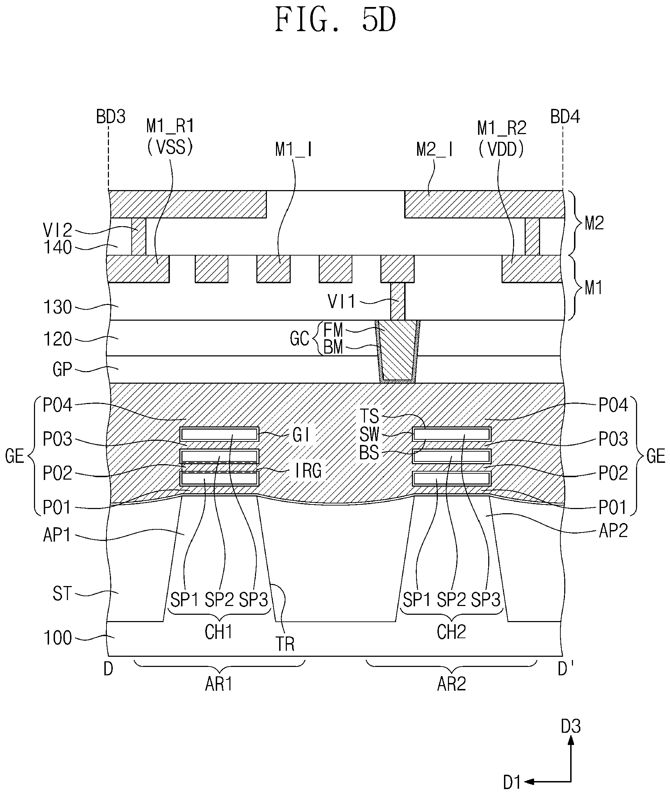

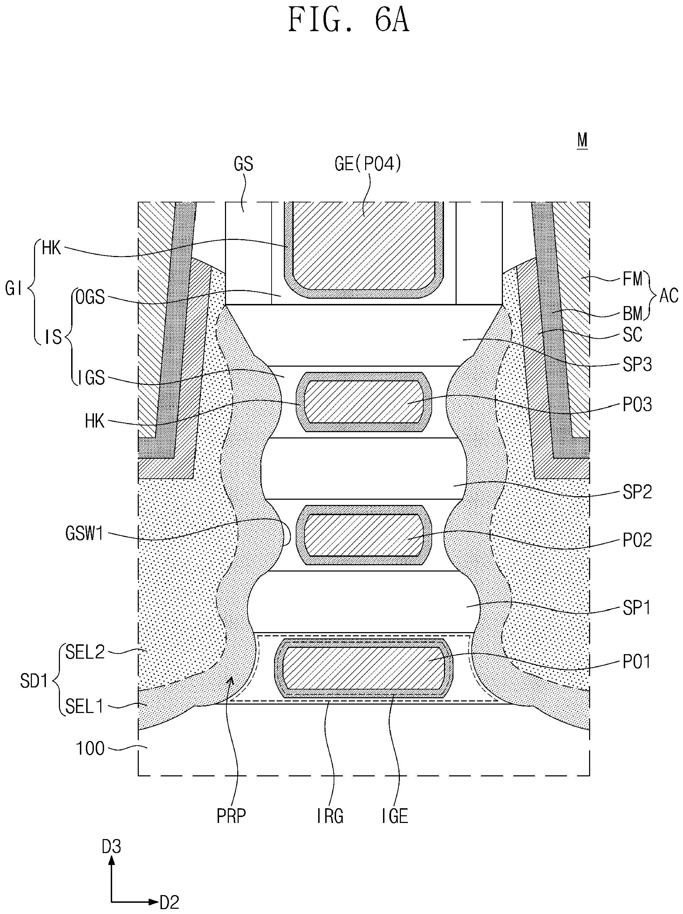

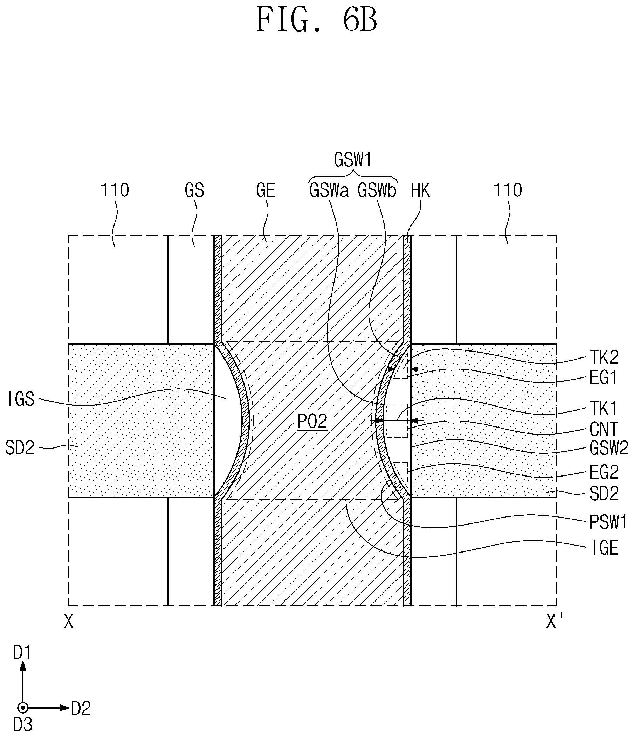

FIG. 4 is a plan view illustrating a semiconductor device according to some example embodiments of the inventive concepts. FIGS. 5A, 5B, 5C, and 5D are cross-sectional views taken along lines A-A', B-B', C-C', and D-D' of FIG. 4, respectively. FIG. 6A is an enlarged view illustrating an embodiment of region 'M' of FIG. 5A. FIG. 6B is a cross-sectional view taken along line X-X' of FIG. 5B. A semiconductor device illustrated in FIGS. 4 and 5A to 5D is an example of the single height cell SHC of FIG. 1 in more detail.

Referring to FIGS. 4 and 5A to 5D, a single height cell SHC may be provided on a substrate 100. Logic transistors constituting a logic circuit may be disposed on the single height cell SHC. The substrate 100 may be a semiconductor substrate including, for example, silicon, germanium, silicon-germanium, and/or the like, or a compound semiconductor substrate. For example, the substrate 100 may be a silicon substrate.

The substrate 100 may include a first active region AR1 and a second active region AR2. Each of the first and second active regions AR1 and AR2 may extend in the second direction D2. As an example, the first active region AR1 may be an NMOSFET region, and the second active region AR2 may be a PMOSFET region.

The first active pattern AP1 and the second active pattern AP2 may be defined by a trench TR (or a device isolation layer ST in the trench TR which will be discussed below) formed on an upper portion (e.g., an upper surface) of the substrate 100. For example, the trench TR (the device isolation layer ST) may be adjacent to the first active pattern AP1 and/or the second active pattern AP2. The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be portions of the substrate 100 and may be vertically protruding portions thereof. For example, the first and second active patterns AP1 and AP2 may protrude in a third direction D3. The third direction D3 may extend perpendicular to the upper surface of the substrate 100. The third direction D3 may intersect with (e.g., be perpendicular to) the first direction D1 and the second direction D2. The third direction D3 may be referred to as a vertical direction.

A device isolation layer ST may be provided on the substrate 100. The device isolation layer ST may at least partially fill the trench TR. The device isolation layer ST may include, for example, a silicon oxide layer. The device isolation layer ST may not cover first and second channel patterns CH1 and CH2 to be described later.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 sequentially stacked. The first, second, and third semiconductor patterns SP1, SP2, and SP3 may be spaced apart from each other in the vertical direction (e.g., in the third direction D3).

Each of the first, second, and third semiconductor patterns SP1, SP2, and SP3 may include, for example, silicon (Si), germanium (Ge), and/or silicon-germanium (SiGe). For example, each of the first, second, and third semiconductor patterns SP1, SP2, and SP3 may include crystalline silicon. In some embodiments of the inventive concepts, the first, second, and third semiconductor patterns SP1, SP2, and SP3 may be stacked nanosheets.

A plurality of first source/drain patterns SD1 may be provided on the first active pattern AP1. A plurality of first recesses RS1 may be formed on the first active pattern AP1. The first source/drain patterns SD1 may be correspondingly provided in the first recesses RS1. The first source/drain patterns SD1 may be impurity regions of a first conductivity type (e.g., n-type). The first channel pattern CH1 may be interposed between a pair of the first source/drain patterns SD1. Herein, a pair of the first source/drain patterns SD1 may refer to the first source/drain patterns SD1 adjacent to each other in the second direction D2. That is, the stacked first, second, and third semiconductor patterns SP1, SP2, and SP3 of the first channel pattern CH1 may connect (e.g., electrically connect) the pair of first source/drain patterns SD1 to each other.

A plurality of second source/drain patterns SD2 may be provided on the second active pattern AP2. A plurality of second recesses RS2 may be formed on the second active pattern AP2. The second source/drain patterns SD2 may be correspondingly provided in the second recesses RS2. The second source/drain patterns SD2 may be impurity regions of a second conductivity type (e.g., p-type). The second channel pattern CH2 may be interposed between a pair of the second source/drain patterns SD2. That is, the stacked first, second, and third semiconductor patterns SP1, SP2, and SP3 of the second channel pattern CH2 may connect (e.g., electrically connect) the pair of second source/drain patterns SD2 to each other. Herein, a pair of the second source/drain patterns SD2 may refer to the second source/drain patterns SD2 adjacent to each other in the second direction D2.

The first and second source/drain patterns SD1 and SD2 may be epitaxial patterns formed through a selective epitaxial growth (SEG) process. For example, an upper surface of each of the first and second source/drain patterns SD1 and SD2 may be higher than an upper surface of the third semiconductor pattern SP3. In some embodiments, the upper surface of at least one of the first and second source/drain patterns SD1 and SD2 may be positioned at substantially the same level as the upper surface of the third semiconductor pattern SP3. Hereinafter, the terms, high (higher), low (lower), and the like may refer to relative distances from the substrate 100. For example, element A higher than element B may mean that element A is disposed farther than element B from the upper surface of the substrate 100 in the vertical direction. The term "level" may refer to a distance from the substrate 100 in the vertical direction (i.e., the third direction D3).

As an embodiment of the inventive concepts, the first source/drain patterns SD1 may include the same semiconductor element (e.g., Si) as the substrate 100. The second source/drain patterns SD2 may include a semiconductor element (e.g., SiGe) having a lattice constant greater than that of the semiconductor element (e.g., Si) of the substrate 100. Thus, the pair of second source/drain patterns SD2 may provide compressive stress to the second channel pattern CH2 therebetween.

A sidewall of each of the first and second source/drain patterns SD1 and SD2 may have a bumpy embossed shape. That is, each sidewall of the first and second source/drain patterns SD1 and SD2 may have a wavy (an uneven) profile. The sidewalls of each of the first and second source/drain patterns SD1 and SD2 may protrude toward first to third portions PO1, PO2, and PO3 of the gate electrode GE, which will be described later.

Gate electrodes GE may be provided to cross the first and second channel patterns CH1 and CH2 and extend in a first direction D1. The gate electrodes GE may be arranged in the second direction D2 with a first pitch. Each of the gate electrodes GE may vertically overlap (e.g., overlap in the third direction D3) the first and second channel patterns CH1 and CH2. As used herein, "an element A overlapping an element B in a direction X" (or similar language) means that there is at least one line that extends in the direction X and intersects both the elements A and B.

The gate electrode GE may include a first portion PO1 interposed between the active pattern (e.g., the first active pattern AP1 or the second active pattern AP2) and the first semiconductor pattern SP1, a second portion PO2 interposed between the first semiconductor pattern SP1 and the second semiconductor pattern SP2, a third portion PO3 interposed between the second semiconductor pattern SP2 and the third semiconductor pattern SP3, and a fourth portion PO4 on the third semiconductor pattern SP3 (uppermost semiconductor pattern).

Referring to FIG. 5D, the gate electrode GE may be provided on an upper surface TS, a lower surface BS, and both (opposite) sidewalls SW of each of the first to third semiconductor patterns SP1, SP2, and SP3. That is, the transistor according to the present embodiment may be a three-dimensional field effect transistor (e.g., Multi-Bridge-Channel (MBC) FET or Gate-All-Around (GAA) FET) in which the gate electrode GE extends around (e.g., surrounds) the channel (e.g., the first channel pattern CH1 and the second channel pattern CH2) in three dimensions.

Referring to FIGS. 4 and 5A to 5D, a pair of gate spacers GS may be respectively disposed on both (opposite) sidewalls of the fourth portion PO4 of the gate electrode GE. The gate spacers GS may extend in the first direction D1 along the gate electrode GE. Upper surfaces of the gate spacers GS may be higher than upper surfaces of the gate electrode GE (e.g., an upper surface of the fourth portion PO4). The upper surfaces of the gate spacers GS may be coplanar with an upper surface of a first interlayer insulating layer 110 to be described later. In some embodiments, the gate spacers GS may include, for example, at least one of SiCN, SiCON, and SiN. In some embodiments, the gate spacers GS may include, for example, a multi-layer formed of at least two of SiCN, SiCON, and SiN.

A gate capping pattern GP may be provided on the gate electrode GE. The gate capping pattern GP may extend in the first direction D1 along the gate electrode GE. The gate capping pattern GP may include a material having etch selectivity with respect to first and second interlayer insulating layers 110 and 120 to be described later. For example, the gate capping pattern GP may include SiON, SiCN, SiCON, and/or SiN.

A gate insulating layer GI may be interposed between the gate electrode GE and the first channel pattern CH1 and between the gate electrode GE and the second channel pattern CH2. The gate insulating layer GI may be on (e.g., cover or overlap) the upper surface TS, the lower surface BS, and both (opposite) sidewalls SW of each of the first, second, and third semiconductor patterns SP1, SP2, and SP3. The gate insulating layer GI may be on (e.g., cover or overlap) an upper surface of the device isolation layer ST under the gate electrode GE.

As an embodiment of the inventive concepts, referring to FIG. 6A, the gate insulating layer GI may include an inner spacer IS and a high dielectric layer HK. Herein the high dielectric layer may be referred to as a high-k dielectric layer. In some embodiments, the inner spacer IS may include an inner gate spacer IGS and an outer gate spacer OGS. Each of the inner gate spacer IGS and the outer gate spacer OGS may include, for example, an insulating material containing silicon (Si). Each of the inner gate spacer IGS and the outer gate spacer OGS may include, for example, a silicon oxide layer, a silicon oxynitride layer, and/or a silicon nitride layer.

The high dielectric layer HK may include a high-k material having a higher dielectric constant than the silicon oxide layer. For example, the high dielectric layer HK may include hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and/or lead zinc niobate.

In some embodiments, the semiconductor device of the inventive concepts may include a negative capacitance (NC) FET using a negative capacitor. For example, the high dielectric layer HK may include a ferroelectric material layer having ferroelectric characteristics, a paraelectric material layer having paraelectric characteristics, or a combination thereof.

The ferroelectric material layer may have a negative capacitance, and the paraelectric material layer may have a positive capacitance. For example, when two or more capacitors are connected (e.g., electrically connected) in series and a capacitance of each capacitor has a positive value, a total capacitance is less than that of each individual capacitor. On the other hand, when at least one of the capacitances of two or more capacitors connected (e.g., electrically connected) in series has a negative value, a total capacitance may have a positive value and may be greater than an absolute value of each individual capacitance.

When a ferroelectric material layer having a negative capacitance and a paraelectric material layer having a positive capacitance are connected (e.g., electrically connected) in series, a total capacitance value of the ferroelectric material layer and the paraelectric material layer connected (e.g., electrically connected) in series may increase. Using the increase in total capacitance value, a transistor including a ferroelectric material layer may have a subthreshold swing (SS) of less than 60 mV/decade at room temperature.

The ferroelectric material layer may have ferroelectric characteristics. The ferroelectric material layer may include, for example, hafnium oxide, hafnium zirconium oxide, barium strontium titanium oxide, barium titanium oxide, and/or lead zirconium titanium oxide. Here, as an example, hafnium zirconium oxide may be a material in which zirconium (Zr) is doped with hafnium oxide. As another example, hafnium zirconium oxide may be a compound of hafnium (Hf), zirconium (Zr), and oxygen (O).

The ferroelectric material layer may further include a dopant. For example, the dopant may include aluminum (Al), titanium (Ti), niobium (Nb), lanthanum (La), yttrium (Y), magnesium (Mg), silicon (Si), calcium (Ca), and cerium (Ce), dysprosium (Dy), erbium (Er), gadolinium (Gd), germanium (Ge), scandium (Sc), strontium (Sr), and/or tin (Sn). Depending on a type of ferroelectric material included in the ferroelectric material layer, a type of dopant included in the ferroelectric material layer (e.g., the dopant) may be various.

When the ferroelectric material layer includes hafnium oxide, the dopant included in the ferroelectric material layer may include, for example, gadolinium (Gd), silicon (Si), zirconium (Zr), aluminum (Al), and/or yttrium (Y).

When the dopant is aluminum (Al), the ferroelectric material layer may include 3 to 8 atomic % (at%) of aluminum. Here, a ratio of the dopant may be a ratio of aluminum to the sum of hafnium and aluminum.

When the dopant is silicon (Si), the ferroelectric material layer may include 2 to 10 at% of silicon. When the dopant is yttrium (Y), the ferroelectric material layer may include 2 to 10 at% of yttrium. When the dopant is gadolinium (Gd), the ferroelectric material layer may include 1 to 7 at% of gadolinium. When the dopant is zirconium (Zr), the ferroelectric material layer may include 50 to 80 at% of zirconium.

The paraelectric material layer may have paraelectric characteristics. The paraelectric material layer may include, for example, silicon oxide and/or a metal oxide having a high dielectric constant (high-k metal oxide). The metal oxide included in the paraelectric material layer may include, for example, hafnium oxide, zirconium oxide, and/or aluminum oxide, but is not limited thereto.

The ferroelectric material layer and the paraelectric material layer may include the same material. The ferroelectric material layer may have ferroelectric characteristics, but the paraelectric material layer may not have ferroelectric characteristics. For example, when the ferroelectric material layer and the paraelectric material layer include hafnium oxide, a crystal structure of hafnium oxide included in the ferroelectric material layer is different from a crystal structure of hafnium oxide included in the paraelectric material layer.

The ferroelectric material layer may have a thickness having ferroelectric characteristics. A thickness of the ferroelectric material layer may be, for example, 0.5 to 10 nm, but is not limited thereto. A critical thickness representing ferroelectric characteristics may be various for each ferroelectric material, and thus the thickness of the ferroelectric material layer may be various depending on the ferroelectric material.

For example, the gate insulating layer GI may include one ferroelectric material layer. As another example, the gate insulating layer GI may include a plurality of ferroelectric material layers spaced apart from each other. The gate insulating layer GI may have a multilayer structure in which a plurality of ferroelectric material layers and a plurality of paraelectric material layers are alternately stacked.

Referring to FIGS. 4 and 5A to 5D, the gate electrode GE may include a first metal pattern and a second metal pattern on the first metal pattern. The first metal pattern may be provided on the gate insulating layer GI and may be adjacent to the first to third semiconductor patterns SP1, SP2, and SP3. The first metal pattern may include a work function metal for adjusting a threshold voltage of the transistor. A desired threshold voltage of the transistor may be achieved by adjusting a thickness and composition of the first metal pattern. For example, the first to third portions PO1, PO2, and PO3 of the gate electrode GE may be formed of (may include) the first metal pattern that is a work function metal.

The first metal pattern may include, for example, a metal nitride layer. For example, the first metal pattern may include nitrogen (N) and at least one metal from among titanium (Ti), tantalum (Ta), aluminum (Al), tungsten (W), and/or molybdenum (Mo). Furthermore, the first metal pattern may further include carbon (C). The first metal pattern may include a plurality of stacked work function metal layers.

The second metal pattern may include a metal having lower resistance than that of the first metal pattern. For example, the second metal pattern may include tungsten (W), aluminum (Al), titanium (Ti), and/or tantalum (Ta). For example, the fourth portion PO4 (e.g., the uppermost portion) of the gate electrode GE may include a first metal pattern and a second metal pattern on the first metal pattern.

A first interlayer insulating layer 110 may be provided on the substrate 100. The first interlayer insulating layer 110 may extend around (e.g., cover or overlap) (in a plan view) the gate spacers GS and the first and second source/drain patterns SD1 and SD2. An upper surface of the first interlayer insulating layer 110 may be substantially coplanar with an upper surface of the gate capping pattern GP and an upper surface of the gate spacer GS. A second interlayer insulating layer 120 covering (e.g., overlapping) the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, the first to fourth interlayer insulating layers 110 to 140 may include a silicon oxide layer.

The single height cell SHC may have a first boundary BD1 and a second boundary BD2 that face (e.g., are opposite to) each other in the second direction D2. The first and second boundaries BD1 and BD2 may extend in the first direction D1. The single height cell SHC may have a third boundary BD3 and a fourth boundary BD4 that face (e.g., are opposite to) each other in the first direction D1. The third and fourth boundaries BD3 and BD4 may extend in the second direction D2.

A pair of separation structures DB facing each other in the second direction D2 may be provided on both (opposite) sides of the single height cell SHC. Herein, a pair of the separation structures DB may refer to the separation structures DB adjacent to each other in the second direction D2. For example, the pair of separation structures DB may be respectively provided on the first and second boundaries BD1 and BD2 of the single height cell SHC. The separation structure DB may extend parallel to the first and second gate electrodes GE1 and GE2 in the first direction D1. A pitch between the separation structure DB and the first and second gate electrodes GE1 and GE2 adjacent thereto may be the same as the first pitch.

The separation structure DB may pass through (e.g., penetrate or extend into) the first and second interlayer insulating layers 110 and 120 and extend (at least partially) into the first and second active patterns AP1 and AP2. The separation structure DB may pass through (e.g., penetrate or extend into) upper portions of each of the first and second active patterns AP1 and AP2. The separation structure DB may electrically separate an active region (e.g., the first active pattern AP1 and/or the second active pattern AP2) of the single height cell SHC from an active region of another cell adjacent thereto.

Active contacts AC electrically connected to the first and second source/drain patterns SD1 and SD2 may be provided through (e.g., to at least partially penetrate or extend into) the first and second interlayer insulating layers 110 and 120, respectively. A pair of active contacts AC may be provided on both (opposite) sides of the gate electrode GE, respectively. When viewed in a plan view, the active contact AC may have a bar shape extending in the first direction D1.

The active contact AC may be a self-aligned contact. That is, the active contact AC may be formed in a self-aligned manner using the gate capping pattern GP and the gate spacer GS. For example, the active contact AC may be on (e.g., cover or overlap) at least a portion of the sidewall of the gate spacer GS. Although not shown, the active contact AC may be on (e.g., cover or overlap) a portion of the upper surface of the gate capping pattern GP.

A metal-semiconductor compound layer SC, for example, a silicide layer, may be interposed between the active contact AC and the first source/drain pattern SD1 and between the active contact AC and the second source/drain pattern SD2, respectively. The active contact AC may be electrically connected to the source/drain patterns SD1 and SD2 through the metal-semiconductor compound layer SC. For example, the metal-semiconductor compound layer SC may include \titanium-silicide, tantalum-silicide, tungsten-silicide, nickel-silicide, and/or cobalt-silicide.

Gate contacts GC electrically may at least partially penetrate or extend into the second interlayer insulating layer 120 and the gate capping pattern GP to be connected (e.g., electrically connected) to the gate electrodes GE. When viewed in a plan view, the gate contacts GC may be disposed to overlap the first active region AR1 and the second active region AR2, respectively. For example, the gate contact GC may be provided on the second active pattern AP2 (refer to FIG. 5B).

As an embodiment of the inventive concepts, referring to FIG. 5B, an upper portion of the active contact AC adjacent to the gate contact GC may be (at least partially) filled with an upper insulating pattern UIP. A lower surface of the upper insulating pattern UIP may be lower than a lower surface of the gate contact GC. That is, an upper surface of the active contact AC adjacent to the gate contact GC may come down (may be located) lower than the lower surface of the gate contact GC by the upper insulating pattern UIP. Accordingly, it is possible to prevent a problem in which a short circuit occurs due to contact between the gate contact GC and the active contact AC adjacent thereto.

Each of the active contact AC and gate contact GC may include a conductive pattern FM and a barrier pattern BM extending around (e.g., at least partially surrounding) the conductive pattern FM. For example, the conductive pattern FM may include aluminum, copper, tungsten, molybdenum, and/or cobalt. The barrier pattern BM may be on (e.g., cover or overlap) sidewalls and a lower surface of the conductive pattern FM. The barrier pattern BM may include, for example, a metal layer/metal nitride layer. The metal layer may include, for example, titanium, tantalum, tungsten, nickel, cobalt, and/or platinum. The metal nitride layer may include, for example, a titanium nitride layer (TiN), a tantalum nitride layer (TaN), a tungsten nitride layer (WN), a nickel nitride layer (NiN), a cobalt nitride layer (CoN), and/or a platinum nitride layer (PtN).

A first metal layer M1 may be provided in the third interlayer insulating layer 130. For example, the first metal layer M1 may include a first power wiring M1_R1, a second power wiring M1_R2, and first wirings M1_I. Herein, the first power wiring M1_R1, the second power wiring M1_R2, and the first wirings M1_I may be collectively referred to as the wirings of the first metal layer M1. Each of the wirings M1_R1, M1_R2, and M1_I of the first metal layer M1 may extend parallel to each other in the second direction D2.

In detail, the first and second power wirings M1_R1 and M1_R2 may be provided on the third and fourth boundaries BD3 and BD4 of the single height cell SHC, respectively. The first power wiring M1_R1 may extend in the second direction D2 along the third boundary BD3. The second power wiring M1_R2 may extend in the second direction D2 along the fourth boundary BD4.

The first wirings M1_I of the first metal layer M1 may be disposed between the first and second power wirings M1_R1 and M1_R2. The first wirings M1_I of the first metal layer M1 may be arranged in the first direction D1 with a second pitch. The second pitch may be smaller than the first pitch. A line width (e.g., a line width in the first direction D1) of each of the first wirings M1_I may be smaller than a line width (e.g., a line width in the first direction D1) of each of the first and second power wirings M1_R1 and M1_R2.

The first metal layer M1 may further include first vias VI1. The first vias VI1 may be provided under the wirings M1_R1, M1_R2, and/or M1_I of the first metal layer M1, respectively. The active contact AC (e.g., the first active contact AC1 and the second active contact AC2) and the wirings of the first metal layer M1 may be electrically connected to each other through the first via VI1. The gate contact GC and the wirings of the first metal layer M1 may be electrically connected to each other through the first via VI1.

The wirings of the first metal layer M1 and the first via VI1 therebelow may be formed through separate processes. In some embodiments, each of the wirings and the first via VI1 of the first metal layer M1 may be formed through, for example, a single damascene process. The semiconductor device according to the present embodiment may be formed using, for example, a process of less than 20 nm.

A second metal layer M2 may be provided in the fourth interlayer insulating layer 140. The second metal layer M2 may include a plurality of second wirings M2_I. Each of the second wirings M2_I of the second metal layer M2 may have a line shape or a bar shape extending in the first direction D1. That is, the second wirings M2_I may extend parallel to each other in the first direction D1.

The second metal layer M2 may further include second vias VI2 respectively provided under the second wirings M2_I. The wirings of the first metal layer M1 and the wirings of the second metal layer M2 (e.g., the second wirings M2_I) may be electrically connected to each other through the second via VI2. For example, the wirings of the second metal layer M2 (e.g., the second wirings M2_I) and the second via VI2 therebelow may be formed together through a dual damascene process.

The wiring of the first metal layer M1 and the wiring of the second metal layer M2 may include the same or different conductive materials. For example, the wirings of the first metal layer M1 and the wirings of the second metal layer M2 may include at least one metal material such as aluminum, copper, tungsten, molybdenum, ruthenium, and/or cobalt. Although not shown, metal layers (e.g., M3, M4, M5, etc.) stacked on the fourth interlayer insulating layer 140 may be additionally disposed. Each of the stacked metal layers may include wirings for routing between cells.

Referring to FIGS. 6A and 6B, the gate electrode GE and the gate insulating layer GI will be described in more detail. Referring to FIG. 6A, the first source/drain pattern SD1 may include protrusions PRP protruding toward the first, second, and third portions PO1, PO2, and PO3 of the gate electrode GE, respectively. The protrusion PRP of the first source/drain pattern SD1 may have a convex sidewall. For example, the protrusion PRP of the first source/drain pattern SD1 may comprise a convex sidewall of the first source/drain pattern SD1. The convex sidewalls of the protrusions PRP may be convex toward corresponding portions among the first, second, and third portions PO1, PO2, and PO3.

According to an embodiment of the inventive concepts, the first to third portions PO1, PO2, and PO3 may have different widths (in the second direction D2). For example, a maximum width of the first portion PO1 in the second direction D2 may be greater than a maximum width of the second portion PO2 in the second direction D2. The maximum width of the second portion PO2 in the second direction D2 may be greater than the maximum width of the third portion PO3 in the second direction D2.

The first source/drain pattern SD1 may include a first semiconductor layer SEL1 and a second semiconductor layer SEL2 on the first semiconductor layer SEL1. In an embodiment, when the first source/drain pattern SD1 is n-type (e.g., has n-type conductivity), the first semiconductor layer SEL1 may include the same semiconductor material as the second semiconductor layer SEL2, for example, silicon (Si). However, a concentration of the n-type impurity (e.g., phosphorus or arsenic) in the second semiconductor layer SEL2 may be greater than a concentration of the n-type impurity in the first semiconductor layer SEL1.

In another embodiment, when the first source/drain pattern SD1 is p-type (e.g., has p-type conductivity), the first semiconductor layer SEL1 may include the same semiconductor material as the second semiconductor layer SEL2, for example, silicon-germanium (SiGe). However, a germanium concentration of the second semiconductor layer SEL2 may be greater than that of the first semiconductor layer SEL1. In addition, a concentration of the p-type impurity (e.g., boron) in the second semiconductor layer SEL2 may be greater than a concentration of the p-type impurity in the first semiconductor layer SEL1.

The first semiconductor layer SEL1 may be in direct contact with the first, second, and third semiconductor patterns SP1, SP2, and SP3. The first semiconductor layer SEL1 may include the aforementioned protrusions PRP. An inner gate spacer IGS, which will be described later, may be on (e.g., cover) the first semiconductor layer SEL1. For example, the inner gate spacer IGS may be in direct contact with the first semiconductor layer SEL1. The first, second, and third portions PO1, PO2, and PO3 of the gate electrode GE may be spaced apart from the first semiconductor layer SEL1 (and the protrusions PRP) by the inner spacer IS (e.g., the inner gate spacer IGS) interposed therebetween.

Inner regions IRG may be provided between the pair of first source/drain patterns SD1. The first to third portions PO1, PO2, and PO3 of the gate electrode GE may be provided in the inner regions IRG, respectively. The inner spacer IS (e.g., the inner gate spacer IGS) and the high dielectric layer HK may be further provided in each of the inner regions IRG.

The inner spacer IS (e.g., the inner gate spacer IGS) may partially fill the inner region IRG. The inner gate spacer IGS may provide an inner gate space IGE. Corresponding portions of the high dielectric layer HK and the first, second, and third portions PO1, PO2, and PO3 may be provided in the inner gate space IGE.

Representatively, referring to FIG. 6B, the second portion PO2 of the gate electrode GE and the gate insulating layer GI extending around (e.g., at least partially surrounding) the second portion PO2 will be described. The gate insulating layer GI may be interposed between the second portion PO2 and the first semiconductor pattern SP1, between the second portion PO2 and the second semiconductor pattern SP2, and between the second portion PO2 and the (adjacent) first source/drain patterns SD1.

The gate insulating layer GI may include an inner gate spacer IGS and a high dielectric layer HK. The inner gate spacer IGS may directly on (e.g., cover) the first semiconductor pattern SP1, the second semiconductor pattern SP2, and the first source/drain pattern SD1. The high dielectric layer HK may be interposed between the inner gate spacer IGS and the second portion PO2. The high dielectric layer HK may directly on (e.g., cover) the surface of the second portion PO2 of the gate electrode GE.

The inner gate spacer IGS may include a center portion CNT and an edge portion EG adjacent to one side of the center portion CNT in the first direction D1. In an embodiment, the center portion CNT and the first and second edge portions EG1 and EG2 on both (opposite) sides of the center portion CNT may be defined by dividing the inner gate spacer IGS into thirds with the same length in the first direction D1. For example, the first and second edge portions EG1 and EG2 may be opposite to each other with respect to the center portion CNT in the first direction D1.

The center portion CNT may have a first thickness TK1 in the second direction D2. The edge portion EG (e.g., each of the first and second edge portions EG1 and EG2) may have a second thickness TK2 in the second direction D2. The first thickness TK1 may be greater than the second thickness TK2. A ratio of the second thickness TK2 to the first thickness TK1 may be in the range of 0.2 to 0.8. A thickness of the inner gate spacer IGS may decrease from the center portion CNT to the edge portion EG (e.g., each of the first and second edge portions EG1 and EG2).

The edge portion EG may include a first edge portion EG1 and a second edge portion EG2 spaced apart from the first edge portion EG1 in the first direction D1. The center portion CNT may be provided between the first edge portion EG1 and the second edge portion EG2. A thickness (in the second direction D2) of the inner gate spacer IGS may increase from the first edge portion EG1 toward the center portion CNT and then reach a maximum value at the center portion CNT. Thereafter, the thickness (in the second direction D2) of the inner gate spacer IGS may decrease from the center portion CNT to the second edge portion EG2. That is, the thickness of the inner gate spacer IGS may vary (e.g., increase and then decrease) in the first direction D1.

The inner gate spacer IGS may include a first sidewall GSW1 adjacent to the second portion PO2 of the gate electrode GE. The first sidewall GSW1 may be a sidewall that is convex toward the second portion PO2 of the gate electrode GE. The second portion PO2 of the gate electrode GE may include a concave sidewall PSW1 corresponding to the first sidewall GSW1. The concave sidewall PSW1 may be on (e.g., in contact with) the inner gate spacer IGS. The high dielectric layer HK may be provided between the concave sidewall PSW1 and the inner gate spacer IGS (e.g., the first sidewall GSW1).

The first sidewall GSW1 may include a first outer surface GSWa and a second outer surface GSWb. The center portion CNT may include the first outer surface GSWa that is on (e.g., in contact with) the high dielectric layer HK. The first edge portion EG1 may include the second outer surface GSWb that is on (e.g., in contact with) the high dielectric layer HK. In this case, the first outer surface GSWa may be more (further) recessed toward the second portion PO2 (in the second direction D2) than the second outer surface GSWb. For example, the first outer surface GSWa may be closer than the second outer surface GSWb to a center portion of the second portion PO2 in the second direction D2. That is, the inner gate spacer IGS may include a structure in which the center portion CNT is more recessed toward the second portion PO2 (in the second direction D2) than the first edge portion EG1. The center portion CNT may be more recessed toward the second portion PO2 (in the second direction D2) than the second edge portion EG2. For example, the center portion CNT may be closer than the first and second edge portions EG1 and EG2 to the center portion of the second portion PO2 in the second direction D2.

According to the present embodiment, a thickness of the inner gate spacer IGS decreases from the center portion CNT to the edge portion EG. Accordingly, when the gate electrode GE is (at least partially) filled in the inner gate space IGE, an entrance into which metal is injected is widened. Accordingly, the gate electrode GE may be uniformly formed without voids. As a result, according to the inventive concepts, the thickness of the inner gate spacer IGS may be changed, thereby improving electrical characteristics of a semiconductor device.

The first, second, and third portions PO1, PO2, and PO3 and the inner gate spacer IGS described with reference to FIG. 6A may be equally applied to the second active region AR2 shown in FIG. 5B. The first, second, and third portions PO1, PO2, and PO3 and the inner gate spacer IGS described with reference to FIG. 6B may be equally applied to the first active region AR1 shown in FIG. 5A.

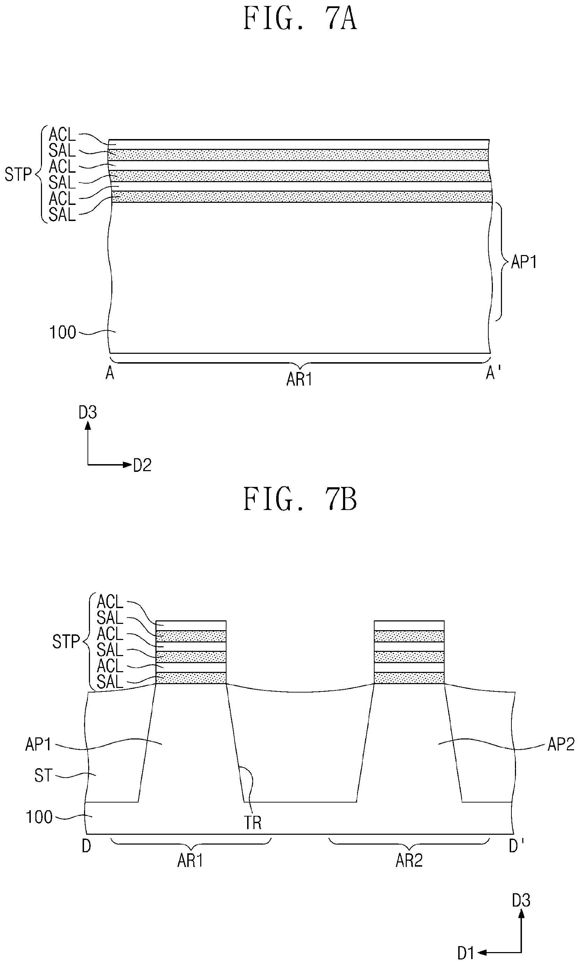

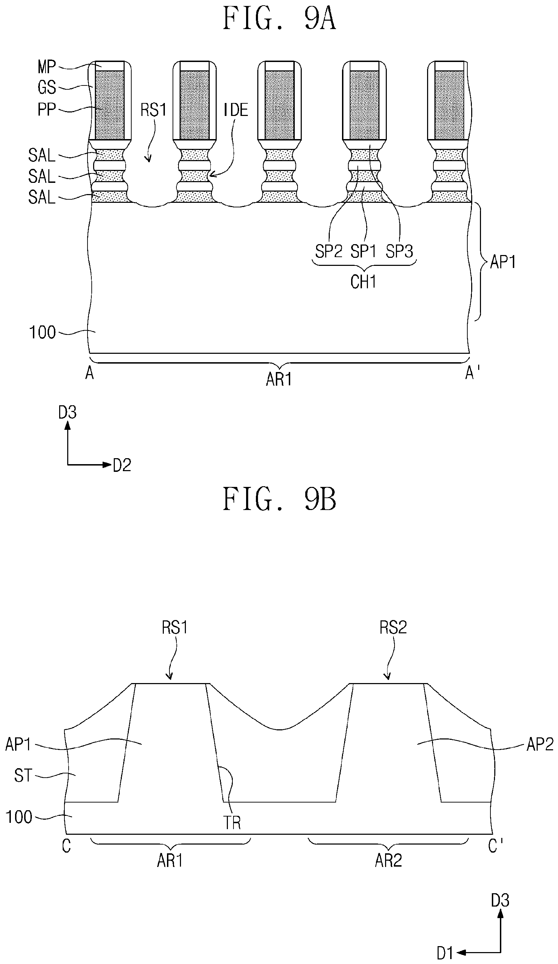

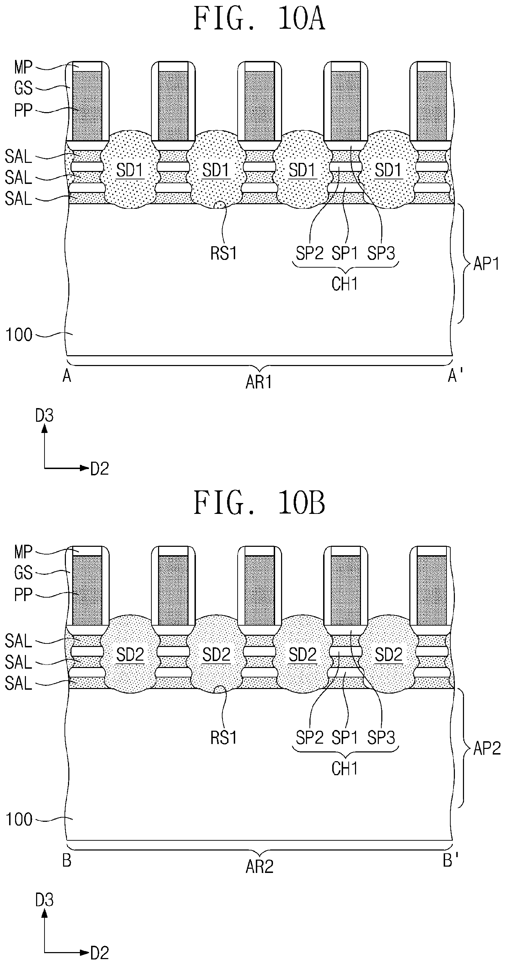

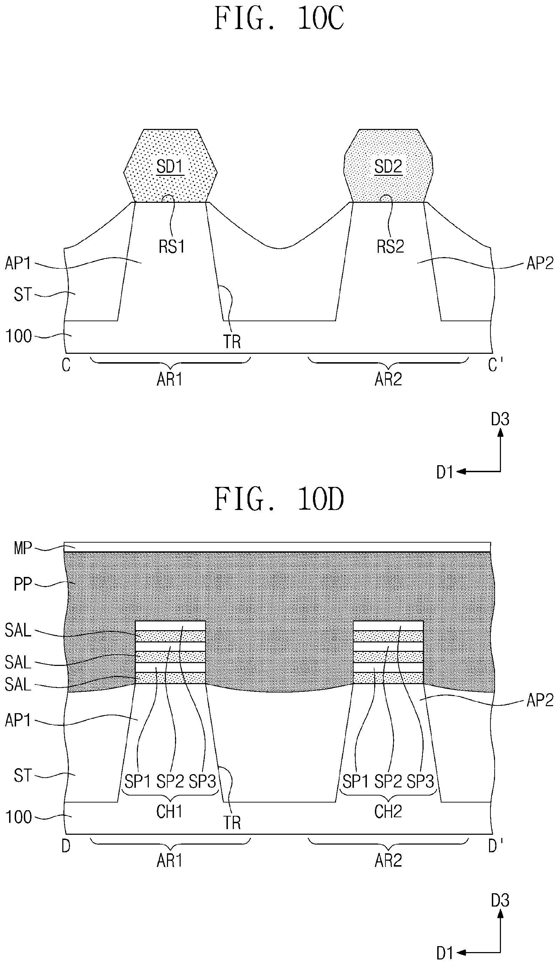

FIGS. 7A to 17B are cross-sectional views illustrating a method of manufacturing a semiconductor device according to some example embodiments of the inventive concepts. In detail, FIGS. 7A, 8A, 9A, 10A, 11A, and 12A are cross-sectional views corresponding to line A-A' of FIG. 4. FIG. 10B is a cross-sectional view corresponding to line B-B' of FIG. 4. FIGS. 9B, 10C, 11B, and 12B are cross-sectional views corresponding to lines C-C' of FIG. 4. FIGS. 7B, 8B, 9C, 10D, 11C, and 12C are cross-sectional views corresponding to line D-D' of FIG. 4.

Referring to FIGS. 7A and 7B, a substrate 100 including first and second active regions AR1 and AR2 may be provided. Active layers ACL and sacrificial layers SAL may be alternately stacked on the substrate 100. The active layers ACL may include one of silicon (Si), germanium (Ge), and silicon-germanium (SiGe), and the sacrificial layers SAL may include another one of silicon (Si), germanium (Ge), and silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). A concentration of germanium (Ge) in each of the sacrificial layers SAL may be 10 at% to 30 at%.

Mask patterns may be respectively formed on the first and second active regions AR1 and AR2 of the substrate 100. The mask pattern may have a line shape or a bar shape extending in a second direction D2.

A patterning process may be performed using the mask patterns as an etch mask to form a trench TR defining first and second active patterns AP1 and AP2. The first active pattern AP1 may be formed on the first active region AR1. The second active pattern AP2 may be formed on the second active region AR2.

A stacked pattern STP may be formed on each of the first and second active patterns AP1 and AP2. The stacked pattern STP may include active layers ACL and sacrificial layers SAL that are alternately stacked with each other. The stacked pattern STP may be formed together with the first and second active patterns AP1 and AP2 during the patterning process.

A device isolation layer ST may be formed to fill (e.g., at least partially fill) the trench TR. For example, an insulating layer may be formed on a surface (e.g., the entire upper and side surfaces) of the substrate 100 to cover the first and second active patterns AP1 and AP2 and the stacked patterns STP. The insulating layer may be recessed until the stacked patterns STP are exposed to form the device isolation layer ST.

The device isolation layer ST may include an insulating material such as a silicon oxide layer. The stacked patterns STP may be exposed on the device isolation layer ST. That is, the stacked patterns STP may vertically protrude from the device isolation layer ST.

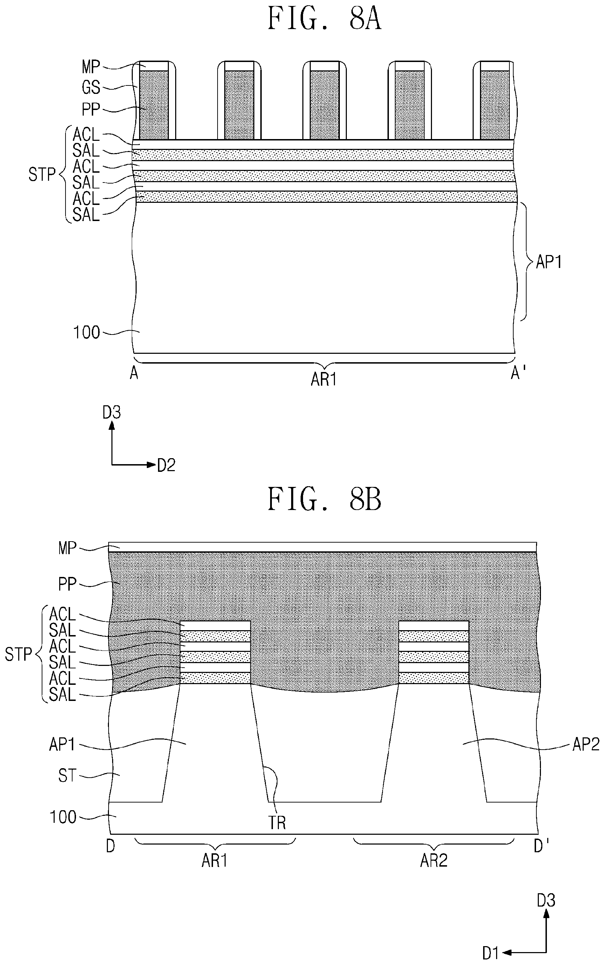

Referring to FIGS. 8A and 8B, sacrificial patterns PP crossing the stacked patterns STP may be formed on the substrate 100. Each of the sacrificial patterns PP may be formed in a line shape or bar shape extending in a first direction D1. The sacrificial patterns PP may be arranged in the second direction D2 with the first pitch.

For example, forming the sacrificial patterns PP may include forming a sacrificial layer on a surface (e.g., the entire upper surface) of the substrate 100, forming hard mask patterns MP on the sacrificial layer, and patterning the sacrificial layer using the hard mask patterns MP as an etching mask. The sacrificial layer may include, for example, polysilicon.

A pair of gate spacers GS may be formed on both (opposite) sidewalls of each of the sacrificial patterns PP. Forming the gate spacers GS may include conformally forming a gate spacer layer on a surface (e.g., the entire upper surface) of the substrate 100 and anisotropically etching the gate spacer layer to form the gate spacers GS. In some embodiments of the inventive concepts, the gate spacer GS may be a multi-layer including at least two layers.

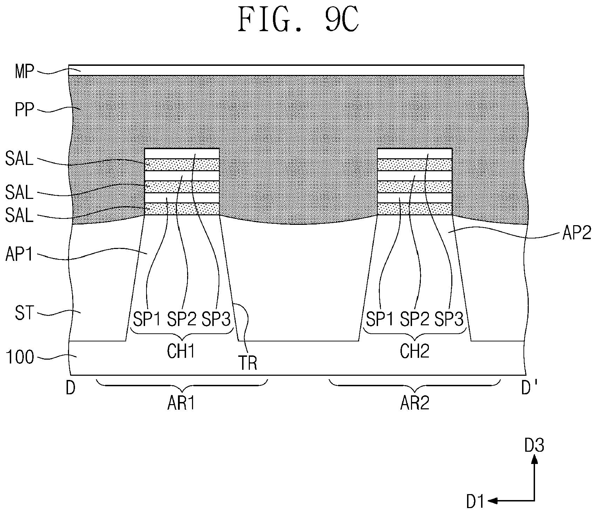

Referring to FIGS. 9A, 9B, and 9C, first recesses RS1 may be formed in the stacked pattern STP on the first active pattern AP1. Second recesses RS2 may be formed in the stacked pattern STP on the second active pattern AP2. While forming the first and second recesses RS1 and RS2, the device isolation layer ST on both (opposite) sides of each of the first and second active patterns AP1 and AP2 may be further recessed (refer to FIG. 9B).

For example, the stacked pattern STP on the first active pattern AP1 may be etched using the hard mask patterns MA and the gate spacers GS as an etch mask to form the first recesses RS1. The first recess RS1 may be formed between a pair of (e.g., between adjacent) sacrificial patterns PP. Forming the first recess RS1 may include additionally performing a selective etching process on the exposed sacrificial layers SAL. Each of the sacrificial layers SAL may be indented by the selective etching process to form an indent region IDE. Accordingly, the first recess RS1 may have a wavy (uneven) inner wall (e.g., inner sidewall). The second recesses RS2 in the stacked pattern STP on the second active pattern AP2 may be formed in the same manner as the first recesses RS1.

From the active layers ACL, first, second, and third semiconductor patterns SP1, SP2, and SP3 sequentially stacked between adjacent first recesses RS1 may be formed, respectively. A first channel pattern CH1 may include the first, second, and third semiconductor patterns SP1, SP2, and SP3 between the adjacent first recesses RS1. A second channel pattern CH2 may include the first, second, and third semiconductor patterns SP1, SP2, and SP3 between adjacent second recesses RS2.

Referring to FIGS. 10A to 10D, first source/drain patterns SD1 may be formed in the first recesses RS1, respectively. For example, an epitaxial layer filling (e.g., at least partially filling) the first recess RS1 may be formed by performing an SEG process using an inner wall (e.g., an inner sidewall) of the first recess RS1 as a seed layer. The epitaxial layer may be grown using the substrate 100 and the first, second, and third semiconductor patterns SP1, SP2, and SP3 exposed by the first recess RS1 as seeds. For example, the SEG process may include a chemical vapor deposition (CVD) process or a molecular beam epitaxy (MBE) process, but is not limited thereto.

As an embodiment, the first source/drain pattern SD1 may include the same semiconductor element (e.g., Si) as the substrate 100. While the first source/drain pattern SD1 is formed, an (n-type) impurity (e.g., phosphorus, arsenic, and/or antimony) that causes the first source/drain pattern SD1 to have an n-type (an n-type conductivity) may be implanted in-situ. In some embodiments, an impurity (e.g., an n-type impurity) may be implanted into the first source/drain pattern SD1 after the first source/drain pattern SD1 is formed.

Second source/drain patterns SD2 may be formed in the second recesses RS2, respectively. For example, the second source/drain pattern SD2 may be formed by performing a SEG process using the inner wall (e.g., the inner sidewall) of the second recess RS2 as a seed layer.

As an embodiment, the second source/drain pattern SD2 may include a semiconductor element (e.g., SiGe) having a lattice constant greater than that of the semiconductor element (e.g., Si) of the substrate 100. While the second source/drain pattern SD2 is formed, an (p-type) impurity (e.g., boron, gallium, or indium) that causes the second source/drain pattern SD2 to have a p-type (a p-type conductivity) may be implanted in-situ. In some embodiments, an impurity (e.g., a p-type impurity) may be implanted into the second source/drain pattern SD2 after the second source/drain pattern SD2 is formed.

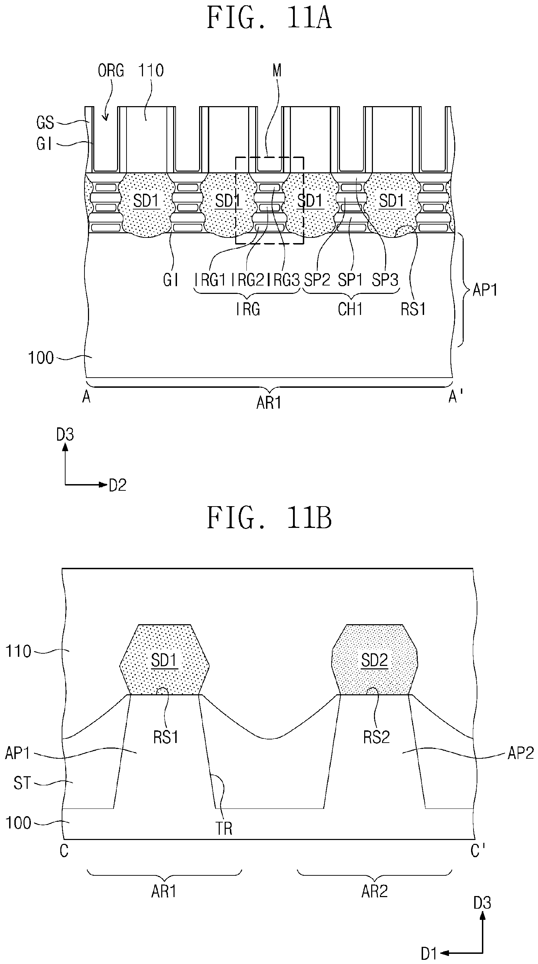

Referring to FIGS. 11A to 11C, a first interlayer insulating layer 110 may be formed on (e.g., to cover) the first and second source/drain patterns SD1 and SD2, the hard mask patterns MP, and the gate spacers GS. For example, the first interlayer insulating layer 110 may include a silicon oxide layer.

The first interlayer insulating layer 110 may be planarized until upper surfaces of the sacrificial patterns PP are exposed. Planarizing the first interlayer insulating layer 110 may be performed using an etch back or chemical mechanical polishing (CMP) process. During the planarization process, all of the hard mask patterns MP may be removed. As a result, the upper surface of the first interlayer insulating layer 110 may be coplanar with the upper surfaces of the sacrificial patterns PP and the upper surfaces of the gate spacers GS.

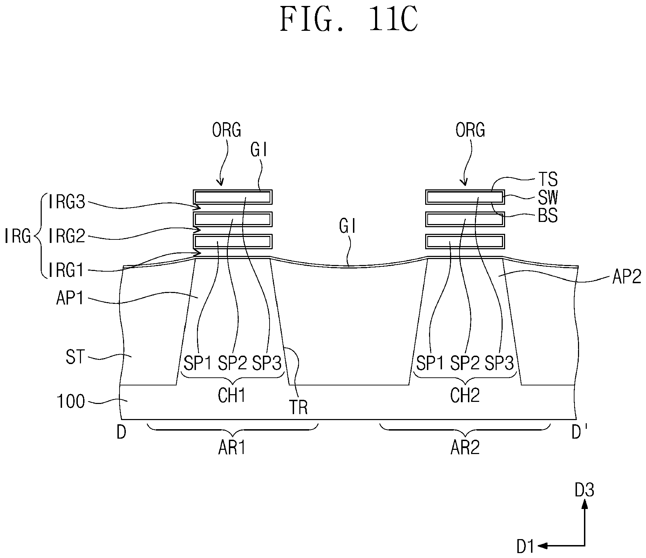

The exposed sacrificial patterns PP may be selectively removed. By removing the sacrificial patterns PP, an outer region ORG exposing the first and second channel patterns CH1 and CH2 may be formed (refer to FIG. 11C). Removing the sacrificial patterns PP may include, for example, wet etching using an etchant that selectively etches the polysilicon.

The sacrificial layers SAL exposed through the outer region ORG may be selectively removed to form inner regions IRG (refer to FIG. 11C). For example, an etching process for selectively etching the sacrificial layers SAL may be performed to remove only the sacrificial layers SAL while leaving the first, second, and third semiconductor patterns SP1, SP2, and SP3 intact. The etching process may have a high etching rate for silicon-germanium having a relatively high germanium concentration. For example, the etching process may have a high etching rate for silicon-germanium having a germanium concentration greater than 10 at%.

During the etching process, the sacrificial layers SAL on the first and second active regions AR1 and AR2 (e.g., the first and second active patterns AP1 and AP2) may be removed. The etching process may be wet etching. An etchant used in the etching process may quickly remove the sacrificial layer SAL having a relatively high germanium concentration.

Referring to FIG. 11C, the sacrificial layers SAL may be by selectively removed, and thus the first, second, and third semiconductor patterns SP1, SP2, and SP3 may remain. First, second, and third inner regions IRG1, IRG2, and IRG3 may be respectively formed through the regions where the sacrificial layers SAL are removed.

For example, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and third semiconductor pattern SP3.

Referring to FIGS. 11A to 11C, a gate insulating layer GI may be formed on the exposed first, second, and third semiconductor patterns SP1, SP2, and SP3. The gate insulating layer GI may be formed to extend around (e.g., at least partially surround) each of the first, second, and third semiconductor patterns SP1, SP2, and SP3. The gate insulating layer GI may be formed in each of the first, second, and third inner regions IRG1, IRG2, and IRG3. The gate insulating layer GI may be formed in the outer region ORG.

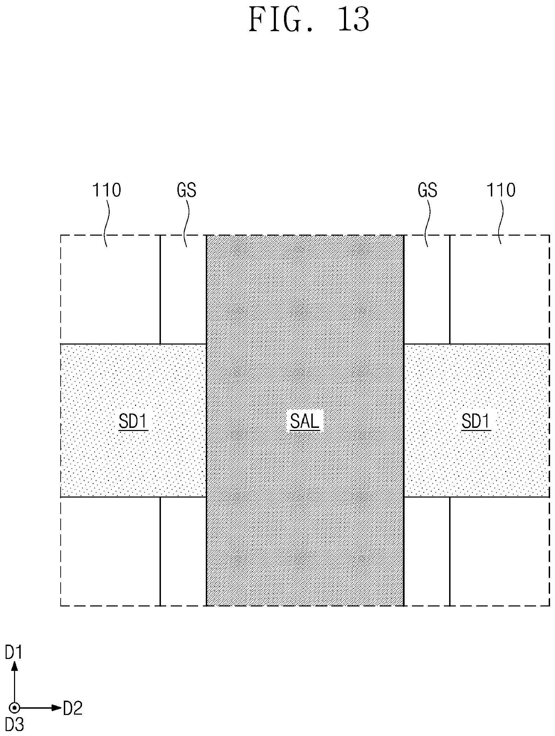

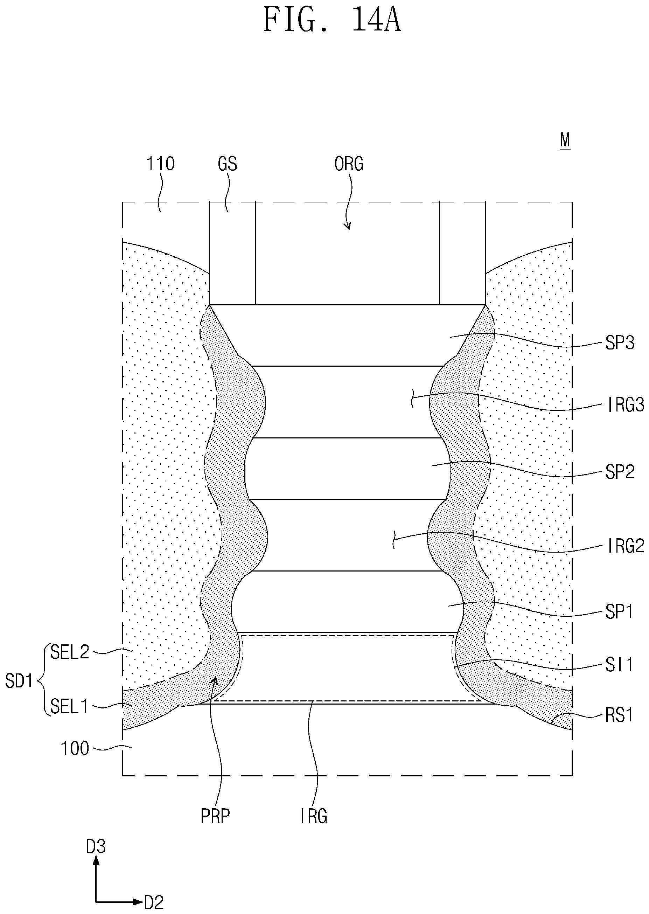

FIGS. 13, 14B, 15B, 16B, and 17B are plan views for explaining a method of manufacturing an inner gate spacer IGS. FIGS. 14A, 15A, 16A, and 17A are cross-sectional enlarged views of region 'M' of FIG. 11A, and are views for explaining a method of manufacturing an inner gate spacer IGS.

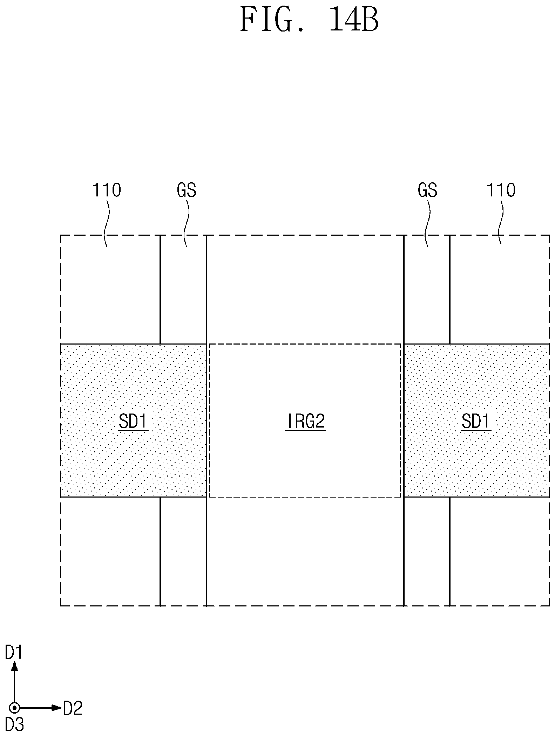

Referring to FIGS. 13, 14A, and 14B, the sacrificial pattern PP may be selectively removed to form the outer region ORG, as described above. The sacrificial layers SAL exposed through the outer region ORG may be selectively removed to form first to third inner regions IRG1 to IRG3. Each of the first to third inner regions IRG1 to IRG3 may be disposed between a pair of (e.g., adjacent) first source/drain patterns SD1.

Due to the indent region IDE shown in FIG. 9A, the first source/drain pattern SD1 may include a protrusion PRP. The protrusion PRP may have a convex sidewall. The second inner region IRG2 may expose an upper surface of the first semiconductor pattern SP1 and a lower surface of the second semiconductor pattern SP2.

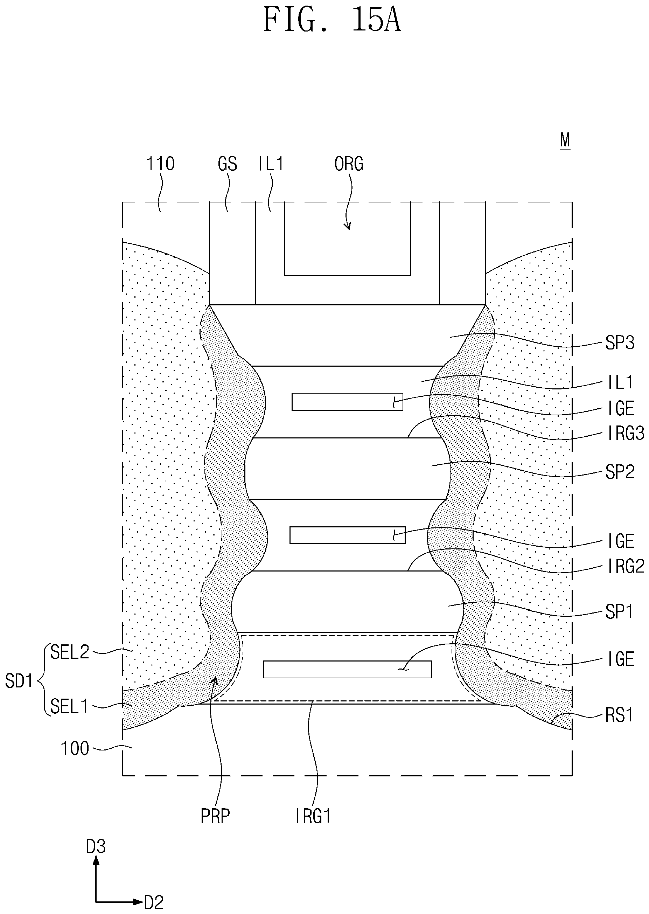

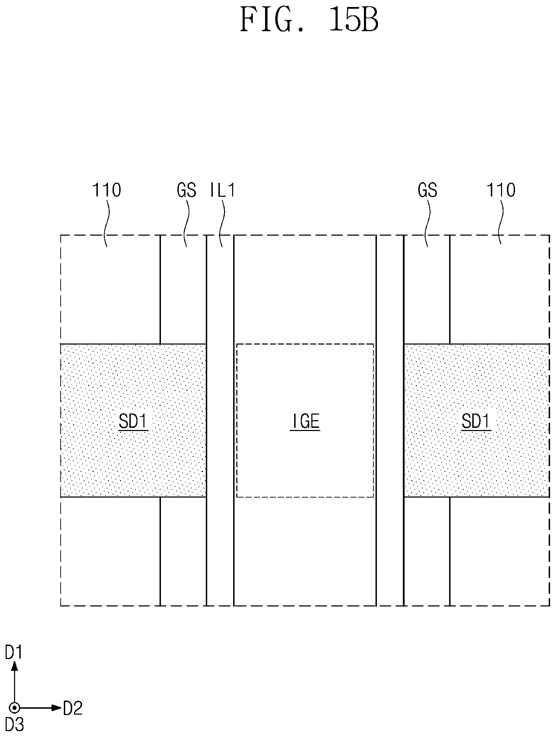

Referring to FIGS. 15A and 15B, the first insulating layer IL1 may be conformally formed in the first to third inner regions IRG1 to IRG3 and the outer region ORG. The first insulating layer IL1 may be formed through a deposition process such as atomic layer deposition (ALD) or CVD. The first insulating layer IL1 may be formed to partially fill, rather than completely fill, the first to third inner regions IRG1 to IRG3. Accordingly, the inner gate space IGE surrounded by the first insulating layer IL1 may be defined (formed) in the first to third inner regions IRG1 to IRG3. For example, the first insulating layer IL1 may include a silicon oxide layer, a silicon oxynitride layer, or a silicon nitride layer.

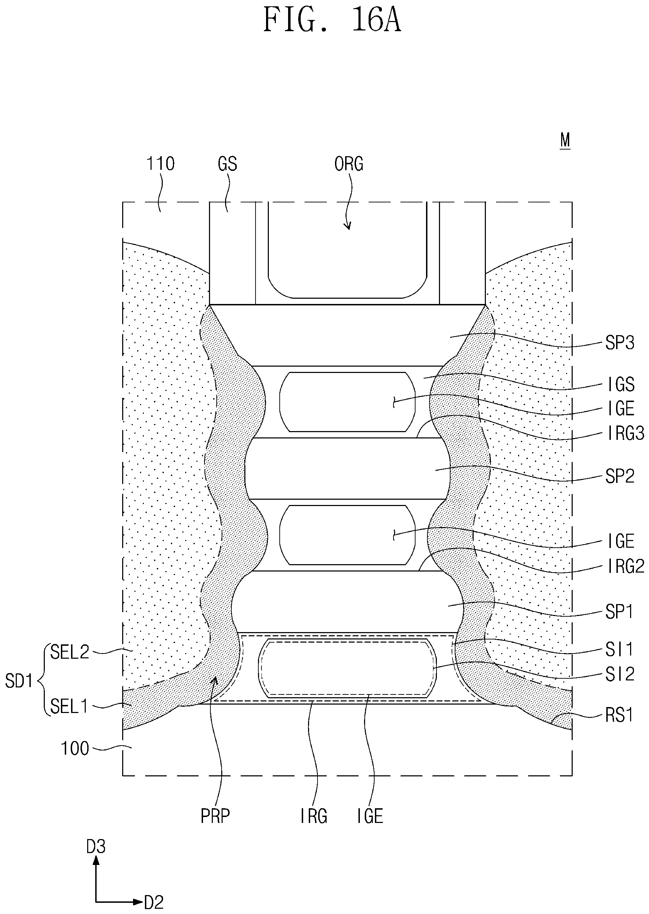

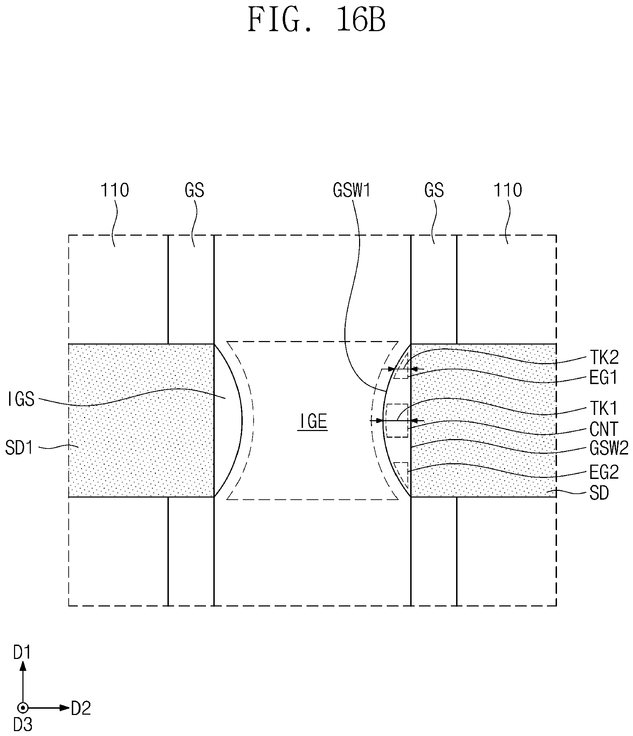

Referring to FIGS. 16A and 16B, the first insulating layer IL1 may be partially and selectively etched. Etching the first insulating layer IL1 may include a wet etching process using an etching solution that selectively etches only the first insulating layer IL1. The etching process may be an isotropic etching process (isotropic etch). For example, an etchant may be provided through the inner gate space IGE to etch the first insulating layer IL1 to form the inner gate spacer IGS. An etchant may be provided through the outer region ORG to etch the first insulating layer IL1 to form the outer gate spacer OGS.

Referring to FIG. 16B, after the etching process, the first insulating layer IL1 may remain on the surface of the first source/drain pattern SD1 to form inner gate spacers IGS. In particular, relatively more the first insulating layer IL1 may remain in the center portion CNT of the inner gate spacer IGS than in the first and second edge portions EG1 and EG2 of the inner gate spacer IGS. That is, a thickness of the inner gate spacer IGS in the second direction D2 of the center portion CNT may be greater than that of the first and second edge portions EG1 and EG2. The center portion CNT may be formed to be thicker than the first and second edge portions EG1 and EG2, and thus the inner gate spacer IGS may include a first sidewall GSW1 that is convex toward the inner gate space IGE.

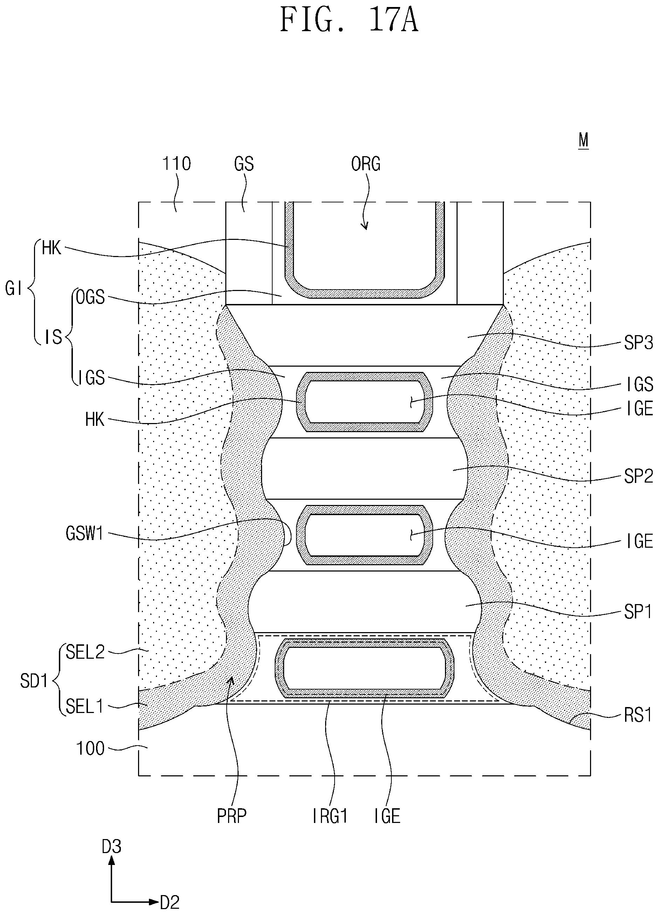

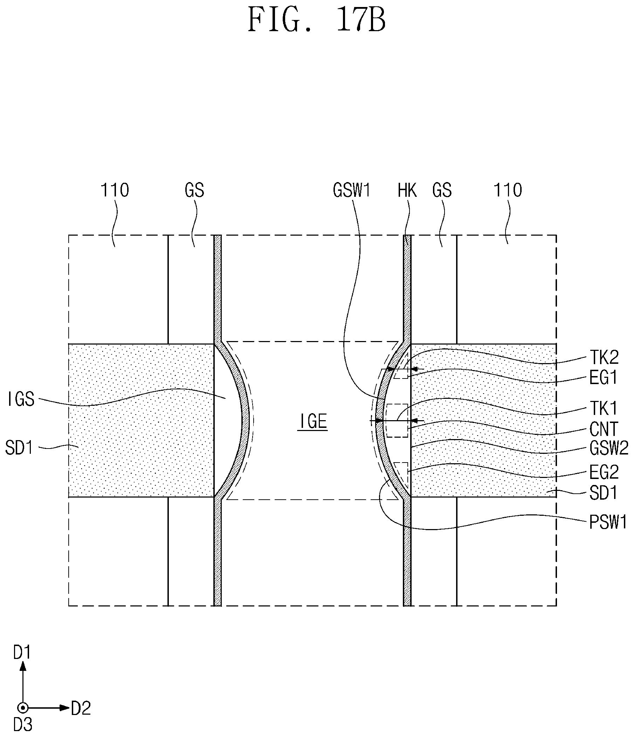

Referring to FIGS. 17A and 17B, a high dielectric layer HK may be formed in the outer region ORG and the first to third inner regions IRG1 to IRG3. The high dielectric layer HK may be formed in the inner gate space IGE. The inner gate spacer IGS, the outer gate spacer OGS, and the high dielectric layer HK may form a gate insulating layer GI. In an embodiment of the inventive concepts, the high dielectric layer HK may be conformally formed. A thickness of the high dielectric layer HK in a horizontal direction (e.g., the second direction D2) may be substantially the same as a thickness in a vertical direction (e.g., the third direction D3).

According to the inventive concepts, the edge portion EG (e.g., the first and second edge portions EG1 and EG2) of the inner gate spacer IGS may be formed to be thinner than the center portion CNT of the inner gate spacer IGS, and thus a certain space sufficient for the gate electrode GE to be filled in each of the first, second, and third inner regions IRG1, IRG2, and IRG3, that is, the inner gate space IGE may be secured. As a process to be described later, when the gate electrode GE is filled in the inner gate space IGE, the gate electrode GE may be uniformly and stably formed without a void. As a result, electrical characteristics of the semiconductor device may be improved.

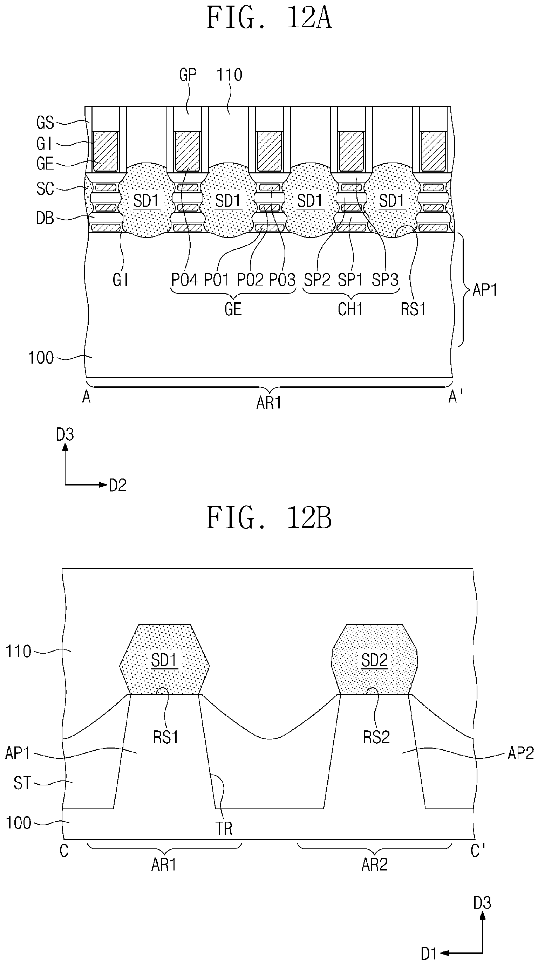

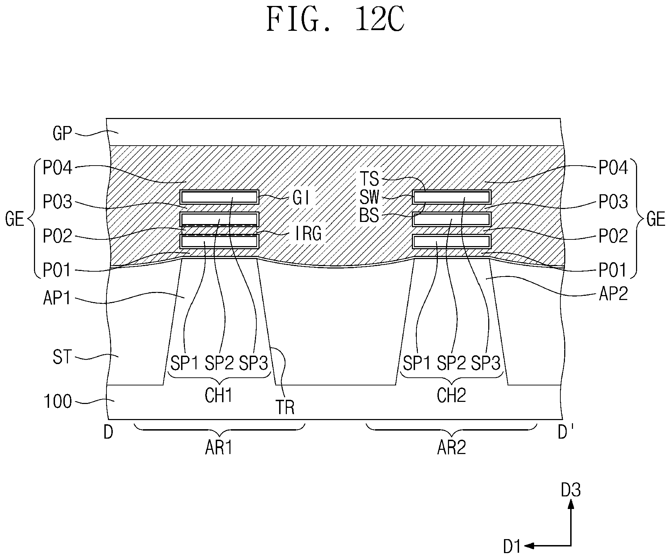

Referring to FIGS. 12A to 12C, a gate electrode GE may be formed on the gate insulating layer GI. The first, second, and third portions PO1, PO2, and PO3 of the gate electrode GE may be respectively formed in the first to third inner regions IRG1, IRG2, and IRG3 and a fourth portion PO4 of the gate electrode GE may be formed in the outer region ORG. Each of the first to third portions PO1, PO2, and PO3 may fill the inner gate space IGE of FIG. 17. As the gate electrode GE is recessed, a height thereof may be reduced. A gate capping pattern GP may be formed on the recessed gate electrode GE.

Referring to FIGS. 5A to 5D, a second interlayer insulating layer 120 may be formed on the first interlayer insulating layer 110. The second interlayer insulating layer 120 may include, for example, a silicon oxide layer. Active contacts AC electrically connected to the first and second source/drain patterns SD1 and SD2 may be formed through (e.g., to at least partially penetrate) the second interlayer insulating layer 120 and the first interlayer insulating layer 110. A gate contact GC electrically connected to the gate electrode GE may be formed through (e.g., to at least partially penetrate) the second interlayer insulating layer 120 and the gate capping pattern GP.

Forming each active contact AC and gate contact GC may include forming a barrier pattern BM and forming a conductive pattern FM on the barrier pattern BM. The barrier pattern BM may be conformally formed and may include, for example, a metal layer/metal nitride layer. The conductive pattern FM may include, for example, a low-resistance metal.

Separation structures DB may be respectively formed on the first boundary BD1 and the second boundary BD2 of the single height cell SHC. The separation structure DB may extend from the second insulating interlayer 120 into the active pattern AP1 or AP2 through the gate electrode GE. The separation structure DB may include an insulating material such as a silicon oxide layer or a silicon nitride layer.

A third interlayer insulating layer 130 may be formed on the active contacts AC and the gate contacts GC. A first metal layer M1 may be formed in the third interlayer insulating layer 130. A fourth interlayer insulating layer 140 may be formed on the third interlayer insulating layer 130. A second metal layer M2 may be formed in the fourth interlayer insulating layer 140.

Hereinafter, various embodiments of the inventive concepts will be described. In embodiments of the inventive concepts to be described later, detailed descriptions of technical features overlapping with those previously described with reference to FIGS. 1 to 6B may be omitted, and differences will be described.

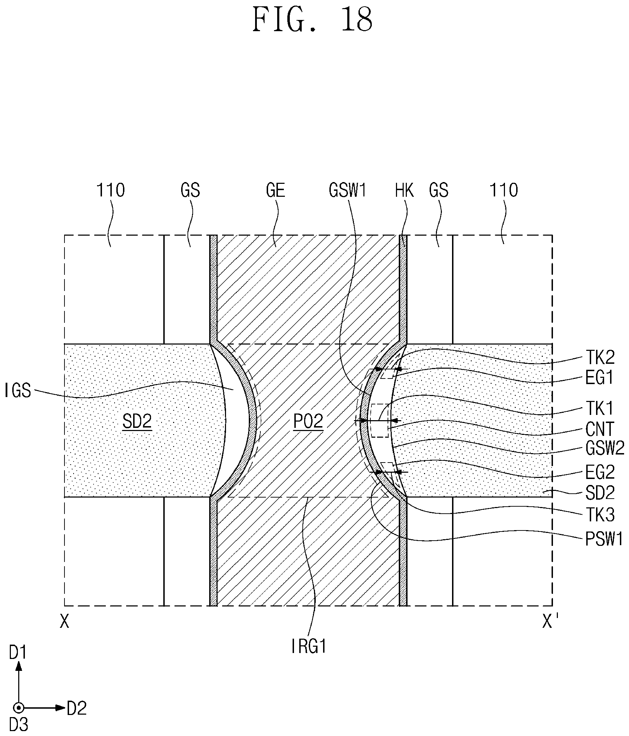

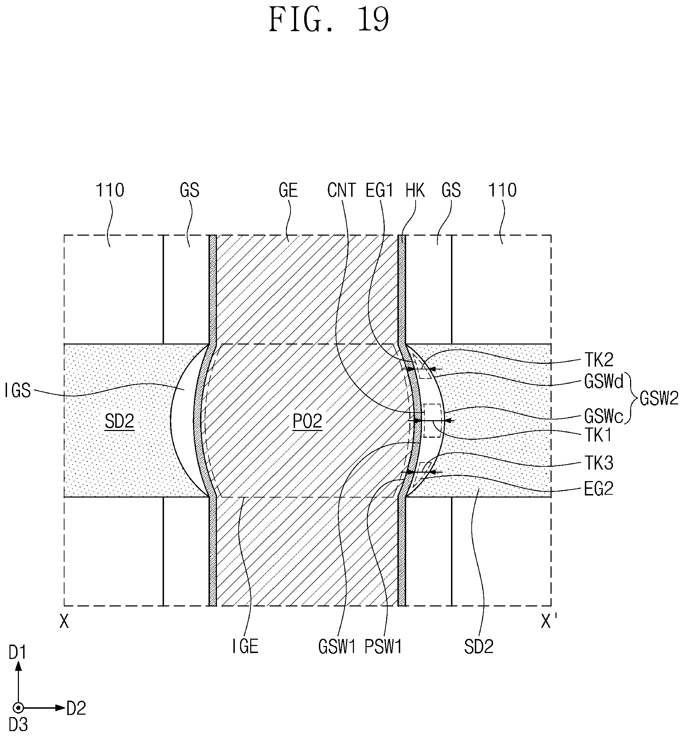

FIGS. 18 and 19 are cross-sectional views taken along line X-X' of FIG. 5B according to some example embodiments of the inventive concepts.

Referring to FIG. 18, an inner gate spacer IGS may include a second sidewall GSW2 in contact with the second source/drain pattern SD2. The second sidewall GSW2 may be a concave sidewall that is recessed toward the second portion PO2. In this case, a curvature of the first sidewall GSW1 may be greater than a curvature of the second sidewall GSW2. Accordingly, a thickness TK1 of the center portion CNT (in the second direction D2) may still be greater than thicknesses TK2 and TK3 of the first and second edge portions EG1 and EG2 (in the second direction D2).

Referring to FIG. 19, a first sidewall GSW1 of the inner gate spacer IGS may be a concave sidewall recessed toward the second source/drain pattern SD2. Corresponding to the first sidewall GSW1, the second portion PO2 may include a sidewall PSW1 that is convex toward the inner gate spacer IGS. The second sidewall GSW2 of the inner gate spacer IGS may be a convex sidewall protruding toward the second source/drain pattern SD2. In this case, a curvature of the second sidewall GSW2 may be greater than that of the first sidewall GSW1. Accordingly, a thickness TK1 of the center portion CNT (in the second direction D2) may still be greater than thicknesses TK2 and TK3 of the first and second edge portions EG1 and EG2 (in the second direction D2).

The center portion CNT may include a third outer surface GSWc (of the second sidewall GSW2). The first edge portion EG1 may include a fourth outer surface GSWd (of the second sidewall GSW2). In this case, the third outer surface GSWc may be more recessed toward the second source/drain pattern SD2 than the fourth outer surface GSWd. For example, the third outer surface GSWc may be closer than the fourth outer surface GSWd to a center portion of the second source/drain pattern SD2 in the second direction D2. That is, the inner gate spacer IGS may include a structure in which the center portion CNT is more recessed toward the second source/drain pattern SD2 than the first edge portion EG1. The center portion CNT may be more recessed toward the second source/drain pattern SD2 than the second edge portion EG2. For example, the center portion CNT may be closer than the first and second edge portions EG1 and EG2 to the center portion of the second source/drain pattern SD2 in the second direction D2.

In the three-dimensional field effect transistor according to the inventive concepts, the gate insulating layer may include the inner gate spacer capable of preventing the leakage current of the gate. When viewed in a plan view, the thickness of the inner gate spacer may decrease from the center portion to the edge portion. As a result, the inner gate electrode may be uniformly and stably filled. As a result, the electrical characteristics of the semiconductor device according to the inventive concepts may be improved.

While embodiments are described above, a person skilled in the art may understand that many modifications and variations are made without departing from the scope of the inventive concepts defined in the following claims. Accordingly, the example embodiments of the inventive concepts should be considered in all respects as illustrative and not restrictive, with the scope of the inventive concepts being indicated by the appended claims.

Embodiments are set out in the following clauses:
Clause 1 A semiconductor device comprising:
   a substrate including an active pattern;
   a channel pattern on the active pattern and including a plurality of stacked semiconductor patterns spaced apart from each other;
   a source/drain pattern connected to the plurality of semiconductor patterns;
   a gate electrode extending in a first direction across the channel pattern and including an inner gate electrode interposed between adjacent first and second semiconductor patterns among the plurality of semiconductor patterns; and
   an inner gate spacer interposed between the inner gate electrode and the source/drain pattern,
   wherein the inner gate spacer includes a center portion and an edge portion adjacent to one side of the center portion in the first direction,
   wherein the center portion has a first thickness in a second direction crossing the first direction,
   wherein the edge portion has a second thickness in the second direction, and
   wherein the first thickness is greater than the second thickness.
Clause 2 The semiconductor device of clause 1, wherein a ratio of the second thickness to the first thickness is 0.2 to 0.8.
Clause 3 The semiconductor device of clause 1 or 2, wherein a thickness of the inner gate spacer decreases from the center portion to the edge portion.
Clause 4 The semiconductor device of any preceding clause, further comprising a high dielectric layer between the inner gate spacer and the inner gate electrode.
Clause 5 The semiconductor device of any preceding clause, wherein the inner gate spacer includes a first sidewall that is convex toward the inner gate electrode.
Clause 6 The semiconductor device of clause 5, wherein the inner gate spacer includes a second sidewall that is in contact with the source/drain pattern and is concave.
Clause 7 The semiconductor device of clause 6, wherein a curvature of the first sidewall is greater than a curvature of the second sidewall.
Clause 8 The semiconductor device of any preceding clause, wherein the inner gate electrode includes a concave sidewall in contact with the inner gate spacer.
Clause 9 The semiconductor device of any preceding clause, wherein the inner gate spacer includes a first outer wall in contact with the source/drain pattern and convex toward the source/drain pattern, and a second outer wall in contact with the inner gate electrode and concave toward the source/drain pattern.
Clause 10 A semiconductor device comprising:
   a substrate including an active pattern;
   a channel pattern on the active pattern and including a plurality of stacked semiconductor patterns spaced apart from each other;
   a source/drain pattern connected to the plurality of semiconductor patterns;
   a gate electrode extending in a first direction across the channel pattern and including an inner gate electrode interposed between adjacent first and second semiconductor patterns among the plurality of semiconductor patterns;
   an inner gate spacer interposed between the inner gate electrode and the source/drain pattern; and
   an inner high dielectric layer between the inner gate electrode and the inner gate spacer,
   wherein the inner gate spacer includes a first portion and a second portion adjacent to one side of the first portion in the first direction,
   wherein the first portion includes a first outer surface in contact with the inner high dielectric layer,
   wherein the second portion includes a second outer surface in contact with the inner high dielectric layer, and
   wherein the first outer surface is more recessed toward the inner gate electrode than the second outer surface.
Clause 11 The semiconductor device of clause 10, wherein the inner gate spacer has a first thickness in a second direction crossing the first direction, and
   wherein the first thickness increases and then decreases in the first direction.
Clause 12 The semiconductor device of clause 10, wherein a thickness of the first portion is greater than a thickness of the second portion.
Clause 13 The semiconductor device of any of clauses 10 to 12, wherein the inner gate spacer includes a first sidewall that is convex toward the inner gate electrode.
Clause 14 The semiconductor device of clause 13, wherein the inner gate spacer further includes a second sidewall in contact with the source/drain pattern and being concave, and
   wherein a curvature of the first sidewall is greater than a curvature of the second sidewall.
Clause 15 The semiconductor device of any of clauses 10 to 14, wherein the inner gate electrode includes a concave sidewall in contact with the inner gate spacer.
Clause 16 A semiconductor device comprising:
   a substrate including an active region;
   a device isolation layer defining an active pattern on the active region;
   a channel pattern and a source/drain pattern on the active pattern, the channel pattern including a plurality of semiconductor patterns spaced apart from each other and vertically stacked;
   a source/drain pattern connected to the plurality of semiconductor patterns;
   a gate electrode extending in a first direction across the channel pattern and including an inner gate electrode interposed between adjacent first and second semiconductor patterns among the plurality of semiconductor patterns;
   an inner gate insulating layer between the first and second semiconductor patterns and the inner gate electrode and including an inner gate spacer interposed between the inner gate electrode and the source/drain pattern;
   an inner high dielectric layer between the inner gate electrode and the inner gate spacer; and
   a gate spacer on the sidewall of the gate electrode,
   wherein the inner gate spacer includes a first edge portion, a second edge portion spaced apart from the first edge portion in the first direction, and a center portion between the first edge portion and the second edge portion, and
   wherein a thickness of the inner gate spacer increases from the first edge portion toward the center portion, reaches a maximum value at the center portion, and then decreases toward the second edge portion from the center portion.
Clause 17 The semiconductor device of clause 16, wherein the inner gate spacer includes a first sidewall that is convex toward the inner gate electrode.
Clause 18 The semiconductor device of clause 17, wherein the inner gate spacer further includes a second sidewall in contact with the source/drain pattern and being concave, and
   wherein a curvature of the first sidewall is greater than a curvature of the second sidewall.
Clause 19 The semiconductor device of any of clauses 16 to 18, wherein the inner gate electrode includes a concave sidewall in contact with the inner gate spacer.
Clause 20 The semiconductor device of any of clauses 16 to 19, wherein the inner gate spacer includes a first outer wall that is convex toward the source/drain pattern, and a second outer wall that is in contact with the inner gate electrode and is concave toward the source/drain pattern.

## Claims

1. A semiconductor device comprising:
a substrate including an active pattern;
a channel pattern on the active pattern, wherein the channel pattern includes a plurality of semiconductor patterns spaced apart from each other;
a source/drain pattern electrically connected to the plurality of semiconductor patterns;
a gate electrode that extends in a first direction on the channel pattern, wherein the gate electrode includes an inner gate electrode that is between first and second semiconductor patterns among the plurality of semiconductor patterns; and
an inner gate spacer between the inner gate electrode and the source/drain pattern, wherein the inner gate spacer includes a center portion and an edge portion that is adjacent to a first side of the center portion in the first direction,
wherein the center portion has a first thickness in a second direction,
wherein the edge portion has a second thickness in the second direction,
wherein the first thickness is greater than the second thickness,
wherein the first and second semiconductor patterns are adjacent to each other in a third direction,
wherein the first direction is parallel with an upper surface of the substrate,
wherein the second direction is parallel with the upper surface of the substrate and intersects with the first direction, and
wherein the third direction is perpendicular to the upper surface of the substrate.

2. The semiconductor device of claim 1, wherein a ratio of the second thickness to the first thickness is 0.2 to 0.8.

3. The semiconductor device of claim 1 or 2, wherein a thickness of the inner gate spacer in the second direction decreases from the center portion to the edge portion.

4. The semiconductor device of any preceding claim, further comprising a high-k dielectric layer between the inner gate spacer and the inner gate electrode.

5. The semiconductor device of any preceding claim, wherein the inner gate spacer includes a first sidewall that is convex toward the inner gate electrode.

6. The semiconductor device of claim 5, wherein the inner gate spacer includes a second sidewall that is in contact with the source/drain pattern and is recessed toward the inner gate electrode.

7. The semiconductor device of claim 6, wherein a curvature of the first sidewall is greater than a curvature of the second sidewall.

8. The semiconductor device of any preceding claim, wherein the inner gate electrode includes a concave sidewall that is on the inner gate spacer.

9. The semiconductor device of any preceding claim, wherein the inner gate spacer includes a first outer wall that is in contact with the source/drain pattern and convex toward the source/drain pattern, and a second outer wall that is on the inner gate electrode and recessed toward the source/drain pattern.

10. A semiconductor device comprising:
a substrate including an active pattern;
a channel pattern on the active pattern, wherein the channel pattern includes a plurality of semiconductor patterns spaced apart from each other;
a source/drain pattern electrically connected to the plurality of semiconductor patterns;
a gate electrode that extends in a first direction on the channel pattern, wherein the gate electrode includes an inner gate electrode that is between first and second semiconductor patterns among the plurality of semiconductor patterns;
an inner gate spacer between the inner gate electrode and the source/drain pattern; and
an inner high-k dielectric layer between the inner gate electrode and the inner gate spacer,
wherein the inner gate spacer includes a first portion and a second portion that is adjacent to a first side of the first portion in the first direction,
wherein the first portion includes a first outer surface in contact with the inner high-k dielectric layer,
wherein the second portion includes a second outer surface in contact with the inner high-k dielectric layer,
wherein the first outer surface is closer than the second outer surface to a center portion of the inner gate electrode, and
wherein the first direction is parallel with an upper surface of the substrate.

11. The semiconductor device of claim 10, wherein the inner gate spacer has a thickness in a second direction,
wherein the second direction is parallel with the upper surface of the substrate and intersects with the first direction, and
wherein the thickness increases and then decreases in the first direction.

12. The semiconductor device of claim 10, wherein a first thickness of the first portion in a second direction is greater than a second thickness of the second portion in the second direction, and
wherein the second direction is parallel with the upper surface of the substrate and intersects the first direction.

13. The semiconductor device of any of claims 10 to 12, wherein the first outer surface is convex toward the inner gate electrode.

14. The semiconductor device of claim 13, wherein the inner gate spacer further includes a second outer surface that is in contact with the source/drain pattern and recessed toward the inner gate electrode, and
wherein a curvature of the first outer surface is greater than a curvature of the second outer surface.

15. The semiconductor device of any of claims 10 to 14, wherein the inner gate electrode includes a concave sidewall that is in contact with the inner high-k dielectric layer.
